(19) Europäisches Patentamt
European Patent Office
Office européen des brevets

(11) EP 2 535 367 A1

(12) **EUROPEAN PATENT APPLICATION**
published in accordance with Art. 153(4) EPC

(43) Date of publication:
**19.12.2012 Bulletin 2012/51**

(21) Application number: **11742298.0**

(22) Date of filing: **10.02.2011**

(51) Int Cl.:
*C08G 73/10 (2006.01)* *B32B 15/08 (2006.01)*
*B32B 15/088 (2006.01)* *B32B 27/34 (2006.01)*
*C08J 5/18 (2006.01)*

(86) International application number:
**PCT/JP2011/052856**

(87) International publication number:
**WO 2011/099555 (18.08.2011 Gazette 2011/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.02.2010 JP 2010028125**
**10.02.2010 JP 2010028124**
**10.02.2010 JP 2010028123**

(71) Applicant: **Ube Industries, Ltd.**
**Ube-shi**
**Yamaguchi 755-8633 (JP)**

(72) Inventors:
- **KOHAMA, Shin-ichiro**
**Ube-shi**
**Yamaguchi 755-8633 (JP)**
- **HISANO, Nobuharu**
**Ube-shi**
**Yamaguchi 755-8633 (JP)**
- **YAMAGUCHI, Hiroaki**
**Ube-shi**
**Yamaguchi 755-8633 (JP)**
- **OISHI, Yoshiyuki**
**Yamaguchi 7558633 (JP)**
- **MIURA, Toru**
**Ichihara-shi**
**Chiba 290-0045 (JP)**
- **YOKOZAWA, Tadahiro**
**Ichihara-shi**
**Chiba 290-0045 (JP)**
- **KOHDA, Masafumi**
**Ichihara-shi**
**Chiba 290-0045 (JP)**
- **OOISHI, Kousuke**
**Ube-shi**
**Yamaguchi 755-8633 (JP)**

(74) Representative: **Mai, Dörr, Besier**
**Patentanwälte**
**Steuerberater/Wirtschaftsprüfer**
**John-F.-Kennedy-Straße 4**
**65189 Wiesbaden (DE)**

(54) **POLYIMIDE FILM, POLYIMIDE LAMINATE COMPRISING SAME, AND POLYIMIDE/METAL LAMINATE COMPRISING SAME**

(57) Disclosed is a polyimide film having improved adhesiveness to an adhesive and/or adherence to a metal layer. The polyimide film has at least a polyimide layer (b) and a polyimide layer (a) formed contacting the polyimide layer (b), wherein the polyimide layer (a) is a polyimide formed from a tetracarboxylic dianhydride component and a diamine component containing a diamine compound represented by general formula (1):

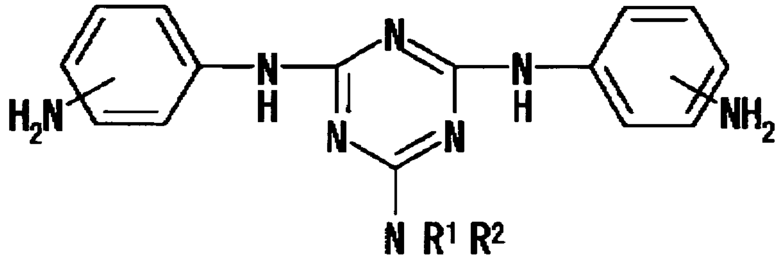

(1)

EP 2 535 367 A1

wherein $R^1$ denotes a hydrogen atom, an alkyl group having 1 to 12 carbon atoms or an aryl group, and $R^2$ denotes an alkyl group having 1 to 12 carbon atoms or an aryl group.

## Description

### TECHNICAL FIELD

The present invention relates to a polyimide film having improved adhesiveness to adhesive(s). This invention also relates to a polyimide laminate where an adhesive layer or a metal layer via an adhesive layer is laminated on a polyimide film, and a polyimide-metal laminate in which a metal layer is directly (without using an adhesive layer) formed on a surface by a dry or wet process.

### BACKGROUND ART

A polyimide film has been extensively used in the fields of electric/electronic devices, semiconductors and so on, because of its excellent heat resistance, chemical resistance, mechanical strength, electric properties, dimensional stability and so on. For example, for a flexible printed circuit board (FPC), there has been used a copper-clad laminated substrate where a copper foil is laminated on one or both sides of a polyimide film.

In general, a polyimide film may not, however, provide a laminate having adequately high peeling strength when a metal layer is formed on a polyimide film by dry plating such as metal deposition and sputtering, or when a metal layer is formed on a polyimide film by wet plating such as electroless plating.

Patent Document 1 has described a polyimide from a triazine-based diamine, showing an example in which a polyimide solution is applied on a metal foil.

As examples of the use of a triazine-based diamine, Patent Document 2 has disclosed an end-modified imide oligomer using a triazine-based diamine and Patent Document 3 has disclosed a polymer electrolyte using a triazine-based diamine.

### PRIOR ART REFERENCES

### PATENT DOCUMENTS

Patent Document 1: U. S. Patent No. 3803075
Patent Document 2: JP A 2009-263570
Patent Document 3: JP A 2009-87763
Patent Document 4: JP A 2010-31102 (unpublished as of the priority date)

### SUMMARY OF THE INVENTION

### PROBLEM TO BE SOLVED BY THE INVENTION

An objective of the present invention is to provide a polyimide film in which adhesiveness to an adhesive and/or adherence to a metal layer are improved. In particular, an objective of an aspect of the present invention is to improve adhesiveness and adherence to a metal layer by modifying the properties of a surface of a polyimide film in which adhesiveness to an adhesive or adherence to a metal layer is not adequately large. More particularly, an objective is to provide a polyimide film with higher peeling strength after heating at a high temperature or heating under the high-temperature and high-humidity conditions for a laminate of a polyimide film and an adhesive, a polyimide-metal laminate formed by laminating a metal foil on a polyimide film via an adhesive layer, or a polyimide-metal laminate formed by directly depositing a metal layer on a polyimide film.

A further objective of the present invention is to provide a laminate of a polyimide film and an adhesive; a polyimide-metal laminate formed by laminating a metal foil via an adhesive layer; or a polyimide-metal laminate formed by directly laminating a metal layer.

### MEANS FOR SOLVING THE PROBLEM

The present invention relates to the followings items.

1. A polyimide film comprising at least a polyimide layer (b) and a polyimide layer (a) formed contacting the polyimide layer (b),
wherein the polyimide layer (a) is a polyimide formed from a tetracarboxylic dianhydride component and a diamine component containing a diamine compound represented by general formula (1):

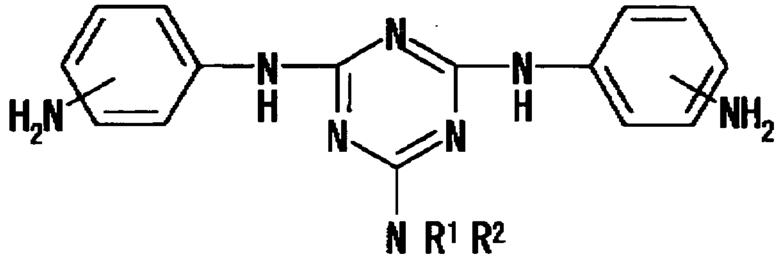

(1)

wherein $R^1$ denotes a hydrogen atom, an alkyl group having 1 to 12 carbon atoms or an aryl group, and $R^2$ denotes an alkyl group having 1 to 12 carbon atoms or an aryl group.

2. The polyimide film according to the above item 1 produced by applying a polymer solution (a) capable of giving the polyimide layer (a) to one side or both sides of a self-supporting film formed from a polyamic acid solution (b) capable of giving the polyimide layer (b) and heating the self-supporting film.

3. The polyimide film according to the above item 1 produced by heating a multilayer liquid film which is a laminate of a liquid film of a polyamic acid solution (b) capable of giving the polyimide layer (b) and a liquid film of a polymer solution (a) capable of giving the polyimide layer (a).

4. The polyimide film according to the above item 2 or 3, wherein the polymer solution (a) is a polyamic acid solution (a) capable of giving the polyimide layer (a).

5. The polyimide film according to any one of the above items 1 to 4, wherein the diamine compound represented by general formula (1) is 2,4-bis(4-aminoanilino)-6-anilino-1,3,5-triazine.

6. The polyimide film according to any one of the above items 1 to 5, wherein the diamine component comprises the diamine compound represented by general formula (1) in a range of 10 to 100 mol%.

7. The polyimide film according to any one of the above items 1 to 5, wherein the diamine component comprises the diamine compound represented by general formula (1) in a range of 25 to 100 mol%.

8. The polyimide film according to any one of the above items 1 to 7, wherein the diamine component further comprises phenylene diamine or diaminodiphenyl ether.

9. The polyimide film according to any one of the above items 1 to 8, wherein a polyimide constituting the polyimide layer (b) is produced from a tetracarboxylic dianhydride component comprising 3,3',4,4'-biphenyltetracarboxylic dianhydride and/or pyromellitic dianhydride and a diamine component comprising phenylene diamine and/or diaminodiphenyl ether.

10. Use of the polyimide film according to any one of the above items 1 to 9 in an application where an adhesive layer is directly formed on the surface of the polyimide layer (a).

11. Use of the polyimide film according to any one of the above items 1 to 9 in an application where a metal layer is formed on the surface of the polyimide layer (a) by dry or wet plating.

12. A polyimide laminate comprising the polyimide film according to any one of the above items 1 to 9 and an adhesive layer formed on the surface of the polyimide layer (a) in the polyimide film.

13. A polyimide-metal laminate wherein a metal layer is laminated in contact with the adhesive layer in the polyimide laminate according to the above item 12.

14. A polyimide-metal laminate comprising the polyimide film according to any one of the above items 1 to 9 and a metal layer formed on the surface of the polyimide layer (a) in the polyimide film by dry or wet plating.

15. A process for manufacturing the polyimide film according to any one of the above items 1 to 9, comprising:

a step of forming a self-supporting film using a polyamic acid solution (b) capable of giving the polyimide layer (b),
a step of applying a polymer solution (a) capable of giving the polyimide layer (a) on one side or both sides of the self-supporting film, and
a heating step of heating the self-supporting film on which the polymer solution (a) is applied.

16. A process for manufacturing the polyimide film according to any one of the above items 1 to 9, comprising:

a step of flow-casting a polyamic acid solution (b) capable of giving the polyimide layer (b) and a polymer solution (a) capable of giving the polyimide layer (a) on a support to form a multilayer liquid film, and
a heating step of heating the multilayer liquid film.

17. The manufacturing process according to the above item 15 or 16, wherein in the heating step, the self-supporting film is heated under such conditions that a maximum heating temperature is 350 °C or higher.

18. The manufacturing process according to the above item 15 or 16, wherein in the heating step, the self-supporting film is heated under such conditions that a maximum heating temperature is 450 °C or higher.

19. The manufacturing process according to the above item 15 or 16, wherein in the heating step, the self-supporting film is heated under such conditions that a maximum heating temperature is 470 °C or higher.

EFFECT OF THE INVENTION

According to the present invention, there is provided a polyimide film having improved adhesiveness to an adhesive or adherence to a metal layer. In particular, according to one aspect of the present invention, even when a polyimide film with inadequate adhesiveness to an adhesive or inadequate adherence to a metal layer is used as a base, its surface properties can be essentially improved, so that adhesiveness to an adhesive and/or adherence (adhesiveness) to a metal layer can be improved while the properties of the polyimide film base are retained.

Furthermore, the present invention can provide a laminate of a polyimide film and an adhesive; a polyimide-metal laminate formed by laminating a polyimide film and a metal foil via an adhesive layer; or a polylmide-metal laminate formed by directly laminating a metal layer on a surface of a polyimide film without using an intervening adhesive.

EMBODIMENT FOR CARRYING OUT THE INVENTION

Broadly speaking, a polyimide film disclosed in this application, at least its surface, is formed from a tetracarboxylic dianhydride component and a diamine component containing a diamine compound represented by general formula (1).

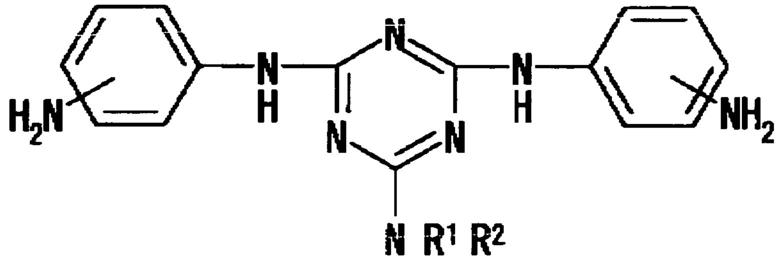

(1)

wherein $R^1$ denotes a hydrogen atom, an alkyl group having 1 to 12 carbon atoms or an aryl group, and $R^2$ denotes an alkyl group having 1 to 12 carbon atoms or an aryl group.

The present invention is generally classified into the first to the third aspects described below.

In the first aspect of the present invention, a polyimide film provided herein comprises at least a polyimide layer (b) and a polyimide layer (a) formed contacting the polyimide layer (b), wherein the polyimide layer (a) is a polyimide formed from a tetracarboxylic dianhydride component and a diamine component containing a diamine compound represented by general formula (1). In the description below, a tetracarboxylic dianhydride component is sometimes simply referred to as a "tetracarboxylic acid component" or an "acid component".

In the second aspect of the present invention, a polyimide film provided herein is that used in an application where the film is directly laminated with an adhesive layer, wherein the polyimide film is formed from a single polyimide layer obtained by reacting a tetracarboxylic dianhydride component and a diamine component containing a diamine compound represented by general formula (1) in a range of more than 0 to 100 mol%, preferably 5 to 100 mol%, further preferably 10 to 100 mol%.

In the third aspect of the present invention, a polyimide film provided herein is that used in an application where a metal layer is directly formed on a film surface by plating without an intervening adhesive layer, wherein the polyimide film is formed from a single polyimide film obtained by reacting a tetracarboxylic dianhydride component and a diamine component containing a diamine compound represented by general formula (1) in a range of 10 to 100 mol%, and then preferably heating them in a heating step under the conditions such that the maximum heating temperature is 450 °C or higher.

The first to the third aspects will be described below in Parts 1 to 3, respectively.

<<Part 1>>

The first aspect of the present invention will be described. The first aspect has at least a polyimide layer (b)

and a polyimide layer (a) formed contacting the polyimide layer (b). Here, a polyimide layer (a) refers to the part corresponding to the polyimide layer (a) among a plurality of layers constituting a polyimide film. A polyimide layer (b) refers to the part corresponding to the polyimide layer (b) among a plurality of layers constituting a polyimide film. These are also applied to embodiments described below.

The polyimide film in the present invention may contain other layers besides the polyimide layers (a) and (b). In this case, a multilayer polyimide film is provided. When a polyimide film has only a structure in which the polyimide layer (a) is laminated on one side of the polyimide layer (b), there is provided a two-layer polyimide film. When a polyimide film has only a structure in which the polyimide layer (a) is laminated on both sides of the polyimide layer (b), there is provided a three-layer polyimide film.

The phrase "formed contacting" as used herein means that the polyimide layer (a) is laminated in contact with the surface of the polyimide layer (b). In the course of producing a polyimide film of the present invention, a contacting region (boundary region) between the polyimide layer (a) and the polyimide layer (b) laminated may be chemically modified by polyamic acid solutions (a) and (b) forming these polyimide layers, to form a layer like an intermediate layer (including a gradient layer in which a composition continuously varies). The present invention also encompasses such an embodiment where an intermediate layer is formed.

The polyimide layer (a) is a polyimide formed from a tetracarboxylic dianhydride component and a diamine component containing a diamine compound represented by formula (1). The polyimide layer (b) has a composition which is the same as or different from the composition of the polyimide layer (a). The description below will be made for embodiments where the polyimide layer (b) has a composition different from that of the polyimide layer (a).

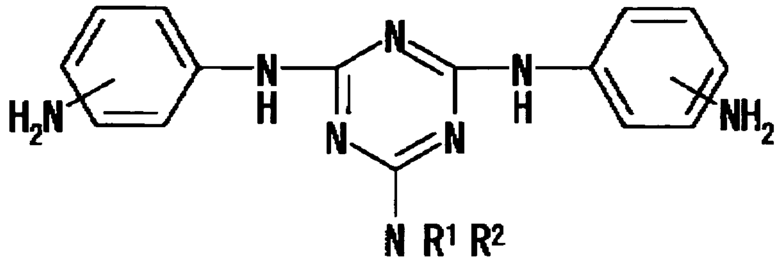

(1)

wherein $R^1$ denotes a hydrogen atom, an alkyl group having 1 to 12 carbon atoms or an aryl group; and $R^2$ denotes an alkyl group having 1 to 12 carbon atoms or an aryl group.

The polyimide layer (a) exhibits excellent adherence to an adhesive layer and/or adherence to a metal layer (formed by wet plating or dry plating) as described below. The polyimide layer (a) may formed in one side or both sides of the polyimide film. The polyimide film may have a further different polyimide layer, but generally has only the polyimide layer (b) and the polyimide layer (a) (in one side or both sides).

The polyimide film of this aspect is advantageous in that its surface properties (for example, adhesiveness to an adhesive and adherence to a metal layer) is improved by the polyimide layer (a) while the excellent properties of the polyimide layer (b) such as mechanical properties and heat resistance are retained. The polyimide layer (a) is also advantageous in that it exhibits excellent alkali resistance.

The polyimide layer (a) can have any appropriate thickness. However, one feature of this aspect is that the surface of the film can be improved without changed the properties of the polyimide layer (b) very much, that is, with making the most of the properties of the polyimide layer (b). Thus, a thickness of the polyimide layer (a) is preferably such that the properties of the polyimide layer (b) does not significantly vary; for example, 1 $\mu$m or less, preferably 0.05 to 1 $\mu$m.

A thickness of the polyimide film is, but not limited to, 5 to 120 $\mu$m, preferably 6 to 75 $\mu$m, further preferably 7 to 60 $\mu$m.

The polyimide film of the first aspect can be produced by any method as long as it is formed such that the polyimide layer (a) and the polyimide layer (b) are in direct contact with each other. Besides preferred methods described below, a polyimide can be obtained, for example, by a process containing flow-casting a solution of a precursor for the polyimide layer (a) (polyamic acid) and a solution of a precursor for the polyimide layer (b) (polyamic acid) on a support by co-extrusion to form a multilayer liquid film, drying them by heating to form a self-supporting film and then heating the product to give a polyimide. A method for flow-casting on a support is not limited to co-extrusion. This method for forming a multilayer liquid film can be also applied to a chemical imidizing method described later.

When a polyimide (a) constituting a polyimide layer (a) is soluble in an organic solvent, a polyimide solution (a) {i.e., a solution of a polyimide (a) dissolved in an organic solvent} can be used for forming the polyimide layer (a) in place of the above solution of a precursor for a polyimide layer (a). When a polyimide (b) constituting a polyimide layer

(b) is soluble in an organic solvent, a polyimide solution (b) {i.e., a solution of a polyimide (b) dissolved in an organic solvent} can be used in place of the above solution of a precursor for a polyimide layer (b) for forming the polyimide layer (b).

It is possible that a material for forming a polyimide layer (a) is a solution of a precursor for a polyimide layer (a) while a material for forming a polyimide layer (b) is a Polyimide solution (b). It is possible that a material for forming a polyimide layer (a) is a polyimide solution (a) while a material for forming a polyimide layer (b) is a solution of a precursor for a polyimide layer (b).

There will be described a preferred method for applying a solution to be a polyimide layer (a) on a surface of a self-supporting film as well as a polyimide layer (a) and a polyimide layer (b).

Typically, a polyimide film according to the first aspect of the present invention is produced by a process comprising the steps of:

flow-casting a polyamic acid solution (b) (polyamic acid + a solvent) capable of giving a polyimide layer (b) on a support and then drying the solution by heating to form a self-supporting film,
applying a polymer solution (a) capable of giving a polyimide layer (a) to one side or both sides of the self-supporting film, and
heating the self-supporting film with the polymer solution (a) applied. A polyimide film according to the first aspect of the present invention is, therefore, preferably a polyimide film prepared by the above production process. Herein, a polymer solution refers to, for example, a polyamic acid solution, a polyimide solution or a mixture of a polyamic acid solution and a polyimide solution.

A polymer solution (a) to be applied is preferably a polyamic acid solution (a), but when a polyimide (a) constituting a polyimide layer (a) is soluble in an organic solvent, a polyimide solution (a) or a mixture of a polyimide solution (a) and a polyamic acid solution (a) may be used.

A polyimide layer (b) in the polyimide film of the present invention is produced by thermal imidization and/or chemical imidization, and when at least one of tetracarboxylic acid component and diamine component contains a plurality of compounds, the film may have a structure formed by random copolymerization, block copolymerization or a combination of these.

With respect to a polyimide layer (a) in the polyimide film of the present invention, when at least one of tetracarboxylic acid component and a diamine component contains a plurality of compounds, it may also have a structure formed by random copolymerization, block copolymerization or a combination of these.

Examples of a process for manufacturing a polyimide film of this aspect generally include

(1) a process comprising the steps of flow-casting a polyamic acid solution (including a polyamic acid solution composition prepared by adding, as necessary, additives selected from an imidization catalyst, a dehydrating agent, a release assisting agent, inorganic fine particles and so on, to a polyamic acid solution) capable of giving a polyimide layer (b) on a support and drying the solution by heating to give a self-supporting film, applying a polymer solution (a) such as a polyamic acid solution (a) to one side or both sides of the self-supporting film, and then thermally cyclodehydrating and desolvating the film to give a polyimide film (a thermal imidization method involving thermal imidization), and
(2) a process comprising the steps of flow-casting a polyamic acid solution containing an imidization catalyst, a cyclization catalyst and a dehydrating agent capable of giving a polyimide layer (b) (including a polyamic acid solution composition further containing, for example, inorganic fine particles) on a support, chemically cyclodehydrating the solution and, as necessary, drying it by heating to give a self-supporting film, applying a polymer solution (a) such as a polyamic acid solution (a) to one side or both sides of the self-supporting film, and then desolvating it by heating for imidization to give a polyimide film (a chemical imidization method involving chemical imidization).

<Tetracarboxylic acid component used in polyimide layer (b), the diamine component>

The specific examples of the tetracarboxylic dianhydride used in polyimide layer (b) include 3,3 ', 4,4' - biphenyl tetracarboxylic dianhydride (s-BPDA) and pyromellitic dianhydride (PMDA), and in addition, 2,3,3',4'-biphenyl tetracarboxylic dianhydride (a-BPDA), oxydiphthalic dianhydride, diphenyl sulfone-3,4,3',4'-tetracarboxylic dianhydride, bis(3,4-dicarboxyphenyl)sulfide dianhydride, 2,2-bis(3,4-dicarboxyphenyl)-1,1,1,3,3,3-hexafluoropropane dianhydride, 2,3,3', 4'-benzophenone tetracarboxylic dianhydride, 3,3',4,4'-benzophenone tetracarboxylic dianhydride, bis(3,4-dicarboxyphenyl)methane dianhydride, 2,2-bis(3,4-dicarboxyphenyl)propane dianhydride, p-phenylene bis(trimellitic acid monoester anhydride), p-biphenylene bis(trimellitic acid monoester anhydride), m-terphenyl-3,4,3',4'-tetracarboxylic dianhydride, p-terphenyl-3, 4, 3', 4'-tetracarboxylic dianhydride, 1,3-bis(3,4-dicarboxyphenoxy)benzene dianhydride, 1,4-bis (3,4-dicarboxyphenoxy)benzene dianhydride, 1,4-bis(3,4-dicarboxyphenoxy)biphenyl dianhydride, 2,2-bis [(3,4-dicarboxyphenoxy)phenyl]propane dianhydride, 2,3,6,7-naphthalene tetracarboxylic dianhydride, 1,4,5,8-naphthalene tetracarboxylic dianhydride, 4,4'-(2,2-hexafluoroisopropylidene)diphthalic dianhydride. These are used alone or in combination of two or more. The tetracarboxylic dianhydride used herein is suitably selected in consideration of desired properties and the like.

The tetracarboxylic acid component preferably comprises at least s-BPDA and/or PMDA, and for example, contains s-BPDA preferably in an amount of 50 mol % or more, more preferably 70 mol % or more, particularly preferably 75 mol % or more, based on 100 mol % of the tetracarboxylic acid component. A polyimide film obtained therefrom is excellent in mechanical property and the like.

The specific examples of diamine used for the polyimide layer (b) include:

1) diamines having one benzene ring, such as para-phenylene diamine(1,4-diaminobenzene;PPD), 1,3-diaminobenzene, 2,4-toluenediamine, 2,5-toluenediamine, 2,6-toluenediamine,
2) diamines having two benzene rings, for example diaminodiphenyl ethers, such as 4,4'-diaminodiphenyl ether, 3,3'-diaminodiphenyl ether, 3,4'-diaminodiphenyl ether; 4,4'-diaminodiphenyl methane, 3,3'-dimethyl-4,4'-diaminobiphenyl, 2,2'-dimethyl-4,4'-diaminobiphenyl, 2,2'-bis(trifluoromethyl)-4,4'-diaminobiphenyl, 3,3'-dimethyl-4,4'-diaminodiphenyl methane, 3,3'-dicarboxy-4,4'-diaminodiphenyl methane, 3,3',5,5'-tetramethyl-4,4'-diaminodiphenyl methane, bis(4-aminophenyl)sulfide, 4,4'-diaminobenzanilide, 3,3'-dichlorobenzidine, 3,3'-dimethylbenzidine, 2,2'-dimethylbenzidine, 3,3'-dimethoxybenzidine, 2,2'-dimethoxybenzidine, 3,3'-diaminodiphenyl ether, 3,4'-diaminodiphenyl ether, 4,4'-diaminodiphenyl ether, 3,3'-diaminodiphenyl sulfide, 3,4'-diaminodiphenyl sulfide, 4,4'-diaminodiphenyl sulfide, 3,3'-diaminodiphenyl sulfone, 3,4'-diaminodiphenyl sulfone, 4,4'-diaminodiphenyl sulfone, 3,3'-diaminobenzophenone, 3,3'-diamino-4,4'-dichlorobenzophenone, 3,3'-diamino-4,4'-dimethoxybenzophenone, 3,3'-diaminodiphenyl methane, 3,4'-diaminodiphenyl methane, 4,4'-diaminodiphenyl methane, 2,2-bis(3-aminophenyl) propane, 2,2-bis(4-aminophenyl)propane, 2,2-bis(3-aminophenyl)-1,1,1,3,3,3-hexafluoropropane, 2,2-bis(4-aminophenyl)-1,1,1,3,3,3-hexafluoropropane, 3,3'-diaminodiphenyl sulfoxide, 3,4'-diaminodiphenyl sulfoxide, 4,4'-diaminodiphenyl sulfoxide,
3) diamines having three benzene rings, for example, 1,3-bis(3-aminophenyl)benzene, 1,3-bis(4-aminophenyl)benzene, 1,4-bis(3-aminophenyl)benzene, 1,4-bis(4-aminophenyl)benzene, 1,3-bis(4-aminophenoxy)benzene, 1,4-bis (3-aminophenoxy)benzene, 1,4-bis(4-aminophenoxy)benzene, 1,3-bis(3-aminophenoxy)-4-trifluoromethylbenzene, 3,3'-diamino-4-(4-phenyl)phenoxybenzophenone, 3,3'-diamino-4,4'-di(4-phenylphenoxy)benzophenone, 1,3-bis(3-aminophenylsulfide)benzene, 1,3-bis(4-aminophenylsulfide)benzene, 1,4-bis(4-aminophenylsulfide)benzene, 1,3-bis(3-aminophenylsulfone)benzene, 1,3-bis(4-aminophenylsulfone)benzene, 1,4-bis(4-aminophenylsulfone)benzene, 1,3-bis[2-(4-aminophenyl)isopropyl]benzene, 1,4-bis[2-(3-aminophenyl)isopropyl]benzene, 1,4-bis [2-(4-aminophenyl)isopropyl]benzene,
4) diamines having four benzene rings, for example, 3,3'-bis(3-aminophenoxy)biphenyl, 3,3'-bis(4-aminophenoxy) biphenyl, 4,4'-bis(3-aminophenoxy)biphenyl, 4,4'-bis(4-aminophenoxy)biphenyl, bis[3-(3-aminophenoxy)phenyl] ether, bis[3-(4-aminophenoxy)phenyl]ether, bis[4-(3-aminophenoxy)phenyl]ether, bis[4-(4-aminophenoxy)phenyl] ether, bis[3-(3-aminophenoxy)phenyl]ketone, bis[3-(4-aminophenoxy)phenyl]ketone, bis[4-(3-aminophenoxy)phenyl]ketone, bis[4-(4-aminophenoxy)phenyl]ketone, bis[3-(3-aminophenoxy)phenyl]sulfide, bis[3-(4-aminophenoxy) phenyl]sulfide, bis[4-(3-aminophenoxy)phenyl]sulfide, bis[4-(4-aminophenoxy)phenyl]sulfide, bis[3-(3-aminophenoxy)phenyl]sulfone, bis[3-(4-aminophenoxy)phenyl]sulfone, bis[4-(3-aminophenoxy)phenyl]sulfone, bis[4-(4-aminophenoxy)phenyl]sulfone, bis[3-(3-aminophenoxy)phenyl]methane, bis[3-(4-aminophenoxy)phenyl]methane, bis [4-(3-aminophenoxy)phenyl]methane, bis[4-(4-aminophenoxy)phenyl]methane, 2,2-bis[3-(3-aminophenoxy)phenyl]propane, 2,2-bis[3-(4-aminophenoxy)phenyl]propane, 2,2-bis[4-(3-aminophenoxy)phenyl]propane, 2,2-bis[4-(4-aminophenoxy)phenyl]propane, 2,2-bis[3-(3-aminophenoxy)phenyl]-1,1,1,3,3,3-hexafluoropropane, 2,2-bis[3-(4-aminophenoxy)phenyl]-1,1,1,3,3,3-hexafluoropropane, 2,2-bis[4-(3-aminophenoxy)phenyl]-1,1,1,3,3,3-hexafluoropropane, 2,2-bis[4-(4-aminophenoxy)phenyl]-1,1,1,3,3,3-hexafluoropropane. These are used alone or in combination of two or more. The diamine used herein is suitably selected in consideration of desired properties and the like.

The diamine component used for polyimide layer (b) comprises diamine compound preferably selected from PPD and diaminodiphenyl ethers, more preferably one or more compound selected from PPD, 4,4'-diaminodiphenyl ether and 3,4'-diaminodiphenyl ether, and particularly preferably comprises PPD, in an amount of 50 mol % or more, more preferably 70 mol % or more, particularly preferably 75 mol % or more, based on the total diamine component (=100 mol %). A polyimide film obtained therefrom is excellent in mechanical property and the like.

As polyimide layer (b), in particular, preference is given to the polyimide produced from s-BPDA, and PPD or PPD and diaminodiphenyl ether(s) such as 4,4'-diaminodiphenyl ether and 3,4'-diaminodiphenyl ether in some cases. Herein, PPD/diaminodiphenyl ethers (molar ratio) is preferably 100/0 to 85/15.

Also, preference is given to polyimide prepared from aromatic tetracarboxylic dianhydride which is PMDA or a combination of s-BPDA and PMDA and aromatic diamine which is PPD, tolidine (ortho-, meta- form) or diaminodiphenyl ethers such as 4,4'-diaminodiphenyl ether, 3,4'-diaminodiphenyl ether. As aromatic diamine, preference is given to PPD,

or PPD/diaminodiphenyl ethers in a proportion of 90/10 to 10/90. In these cases, s-BPDA/PMDA is preferably 0/100 to 90/10.

In addition, preference is also given to polyimide prepared from PMDA and PPD and diaminodiphenyl ether(s) such as 4,4'-diaminodiphenyl ether and 3,4'-diaminodiphenyl ether. In this case, diaminodiphenyl ether(s)/PPD is preferably 90/10 to 10/90.

<Tetracarboxylic acid component and diamine component used for a polyimide layer (a)>

As tetracarboxylic acid component used for the polyimide layer (a), the same tetracarboxylic acid component as that used for a polyimide layer (b) is used, and preferred one is also the same.

A diamine component used for a polyimide layer (a) includes, as described above, a diamine compound represented by formula (1), and a diamine compound represented by formula (1) is contained preferably in an amount of 10 to 100 mol%, more preferably 15 to 100 mol%, further preferably 25 to 100 mol% based on the total diamine component (=100 mol%).

For a polyimide layer (a), the content of a diamine compound represented by formula (1) in the diamine component is preferably 10 to 50 mol%, more preferably 15 to 40 mol%, particularly preferably 17 to 30 mol% in the light of a 5 % weight loss temperature (determined by TGA in the air). Here, a 5% weight loss temperature is an index indicating heat resistance and thermal stability of a film, and a higher value is better.

As the diamine component used for a polyimide layer (a), there can be used, in addition to the diamine represented by general formula (1), a diamine component used for the above polyimide layer (b), and is preferably a diamine component selected from PPD and diaminodiphenyl ethers, more preferably a diamine component containing one or more selected from PPD, 4,4'-diaminodiphenyl ether and 3,4'-diaminodiphenyl ether. A polyimide film obtained therefrom is excellent in mechanical properties, thermal properties or the like.

A polyimide layer (a) is, inter alia, preferably a polyimide formed from a polyamic acid prepared from a tetracarboxylic acid component containing s-BPDA and/or PMDA and a diamine represented by general formula (1) or a diamine component containing a diamine represented by general formula (1) and PPD or a diaminodiphenyl ether such as 4,4'-diaminodiphenyl ether and 3,4'-diaminodiphenyl ether.

A polyimide of the present invention is preferably free from at least one proton-conducting functional group selected from the group consisting of $-SO_3H$, -COOH and $-PO_3H_2$ as described in Patent Document 3, for excellent heat resistance, which is also applicable to the other aspects.

In a diamine compound represented by formula (1),

$R^1$ denotes a hydrogen atom, an alkyl group having 1 to 12 carbon atoms (preferably 1 to 10 carbon atoms, further preferably 1 to 6 carbon atoms) or an aryl group,

$R^2$ denotes an alkyl group having 1 to 12 carbon atoms (preferably 1 to 10 carbon atoms, further preferably 1 to 6 carbon atoms) or an aryl group, and $R^1$ and $R^2$ may be the same or different.

Specific examples of an alkyl group having 1 to 12 carbon atoms and an aryl group for $R^1$ and $R^2$ include methyl, ethyl, propyl, isopropyl, butyl, isobutyl, t-butyl, phenyl, benzyl, naphthyl, methylphenyl and biphenyl.

Aminoanilino groups attached to two NH groups in triazine are 4-aminoanilino or 3-aminoanilino, and can be the same or different; preferably 4-aminoanilino.

The specific examples of diamine represented by general formula (1) include 2,4-bis(4-aminoanilino)-6-anilino-1,3,5-triazine, 2,4-bis(3-aminoanilino)-6-anilino-1,3,5-triazine, 2,4-bis(4-aminoanilino)-6-benzylamino-1,3,5-triazine, 2,4-bis(3-aminoanilino)-6-benzylamino-1,3,5-triazine, 2,4-bis(4-aminoanilino)-6-naphthylamino-1,3,5-triazine, 2,4-bis(4-aminoanilino)-6-biphenylamino-1,3,5-triazine, 2,4-bis(4-aminoanilino)-6-diphenylamino-1,3,5-triazine, 2,4-bis(3-aminoanilino)-6-diphenylamino-1,3,5-triazine, 2,4-bis(4-aminoanilino)-6-dibenzylamino-1,3,5-triazine, 2,4-bis(4-aminoanilino)-6-dinaphthylamino-1,3,5-triazine, 2,4-bis(4-aminoanilino)-6-N-methylanilino-1,3,5-triazine, 2,4-bis(4-aminoanilino)-6-N-methylnaphthylamino-1,3,5-triazine, 2,4-bis(4-aminoanilino)-6-methylamino-1,3,5-triazine, 2,4-bis(3-aminoanilino)-6-methylamino-1,3,5-triazine, 2,4-bis(4-aminoanilino)-6-ethylamino-1,3,5-triazine, 2,4-bis(3-aminoanilino)-6-ethylamino-1,3,5-triazine, 2,4-bis(4-aminoanilino)-6-dimethylamino-1,3,5-triazine, 2,4-bis(3-aminoanilino)-6-dimethylamino-1,3,5-triazine, 2,4-bis(4-aminoanilino)-6-diethylamino-1,3,5-triazine, 2,4-bis(4-aminoanilino)-6-dibutylamino-1,3,5-triazine, 2,4-bis(4-aminoanilino)-6-amino-1,3,5-triazine, 2,4-bis(3-aminoanilino)-6-amino-1,3,5-triazine.

<Preparation of a polyamic acid solution or polyimide solution>

A polyamic acid solution (b) to give a polyimide layer (b) and a polyamic acid solution (a) or a polyimide solution (a) as a polymer solution to give a polyimide layer (a) can be prepared by polymerization in an organic polar solvent using an acid component and a diamine component either in substantially equimolar amounts or in amounts such that one of the components is slightly in excess of the other.

Examples of an organic polar solvent in preparation of a polyamic acid solution or a polyimide solution include

amides such as N-methyl-2-pyrrolidone, N,N-dimethylacetamide, N,N-diethylacetamide, N,N-dimethylformamide, N,N-diethylformamide and hexamethylsulforamide; sulfoxides such as dimethyl sulfoxide and diethyl sulfoxide; and sulfones such as dimethyl sulfone and diethyl sulfone. These solvents may be used alone or in combination.

In a polymerization reaction for providing a polyamic acid solution (a), a polyamic acid solution (b) or a polyimide solution (a), a concentration of all monomers in an organic polar solvent (a solid concentration in a polyamic acid solution) may be appropriately selected, depending on an intended use and a production objective. For example, in a case of coating process, for a polyamic acid solution (b), a concentration of all monomers in an organic polar solvent is preferably 5 to 40 % by mass, further preferably 6 to 35 % by mass, particularly preferably 10 to 30 % by mass. For a polyamic acid solution (a) and a polyimide solution (a), the concentration can be appropriately determined within the range where a polymerization reaction can proceed and be easily handled. As described later, a solid concentration of a polymer solution (a) used for coating is preferably 1 to 15 % by mass, more preferably 2 to 8 % by mass. Therefore, a monomer concentration in polymerization can be determined such that the above concentration is obtained at the end of the polymerization, or polymerization can be conducted at a high concentration and then the solution may be diluted to give a coating solution.

In the above-mentioned process for forming a multilayer liquid film by flow-casting on a support, it is preferable that a concentration of all monomers in an organic polar solvent is higher than that in the case of coating process. A polyimide film having desired properties is produced by an optimal film-forming process such as a process involving coating (applying) and curing to obtain a multilayer film or a process involving cast-flowing a solution on a support to form a multilayer liquid film before curing.

For forming a polyimide layer, three or more monomer components (acid component and diamine component) may be blended to copolymerize thereof, or a plurality of polymer solutions can be prepared and then mixed. "A plurality of polymer solutions are prepared and then mixed" means that, for example, a polymer solution (dope solution) obtained from the first acid component and the first diamine component and a polymer solution (dope solution) obtained from the second acid component and the second diamine component are mixed.

As an example of a process for preparing a polyamic acid solution (a) and a polyamic acid solution (b), the above polymerization reaction of the aromatic tetracarboxylic acid component and the aromatic diamine component can be conducted, for example, by mixing them in substantially equimolar amounts or in amounts such that one of them is slightly in excess of the other component (the acid component or the diamine component) and reacting them at a reaction temperature of 100 °C or lower, preferably 80 °C or lower for about 0.2 to 60 hours to give a polyamic acid solution.

As an example of a process for preparing a polyimide solution (a), the above polymerization reaction of the aromatic tetracarboxylic acid component and the aromatic diamine component can be conducted, for example, by mixing them in substantially equimolar amounts or in amounts such that one of them is slightly in excess of the other component (the acid component or the diamine component) and processed by a known method to give a polyimide solution; for example, the mixture may be reacted at a reaction temperature of 140 °C or higher, preferably 160 °C or higher (preferably 250 °C or lower, further preferably 230 °C or lower) for about 1 to 60 hours to give a polyimide solution.

In conducting a polymerization reaction for preparing a polyamic acid solution (a), a polyimide solution (a) or a polyamic acid solution (b), a solution viscosity is appropriately selected, depending on an intended use (coating, flow casting and so on) and/or a production objective. In the light of workability in handling the polyamic acid solution, a rotational viscosity of the polyamic acid solution as determined at 30 °C is preferably about 0.1 to 5000 poise, particularly preferably about 0.5 to 2000 poise, further preferably about 1 to 2000 poise. Therefore, the above polymerization reaction preferably proceeds to such an extent that a polyamic acid formed has a viscosity as described above.

For thermal imidization, a polyamic acid solution may contain, as necessary, an imidization catalyst, an organic phosphorous-containing compound, inorganic fine particles or the like. For chemical imidization, a polyamic acid solution may contain, as necessary, a cyclization catalyst, a dehydrating agent, inorganic fine particles or the like. A polyimide solution may contain, as necessary, inorganic fine particles or the like.

Examples of an imidization catalyst include substituted or unsubstituted nitrogen-containing heterocyclic compounds, N-oxide compounds of the nitrogen-containing heterocyclic compounds, substituted or unsubstituted amino acid compounds, hydroxy-containing aromatic hydrocarbon compounds or aromatic heterocyclic compounds. Particularly preferably used is lower-alkylimidazoles such as 1,2-dimethylimidazole, N-methylimidazole, N-benzyl-2-methylimidazole, 2-methylimidazole, 2-ethyl-4-methylimidazole and 5-methylbenzimidazole; benzimidazoles such as N-benzyl-2-methylimidazole; isoquinoline; and substituted pyridines such as 3,5-dimethylpyridine, 3,4-dimethylpyridine, 2,5-dimethylpyridine, 2,4-dimethylpyridine and 4-n-propylpyridine. The amount of the imidization catalyst is preferably about 0.01 to 2 equivalents, particularly preferably about 0.02 to 1 equivalents based on amide acid units in a polyamide acid. The use of an imidization catalyst sometimes improves physical properties of a polyimide film obtained, particularly elongation and edge-break resistance.

Examples of an organic phosphorous-containing compound include phosphoric esters such as monocaproyl phosphoric ester, monooctyl phosphoric ester, monolauryl phosphoric ester, monomyristyl phosphoric ester, monocetyl phosphoric ester, monostearyl phosphoric ester, tirethyleneglycol monotridecyl ether monophosphoric ester, tetraethyleneglycol monolauryl ether monophosphoric ester, diethyleneglycol monostearyl ether monophosphoric ester, dicaproyl phosphoric ester, dioctyl phosphoric ester, dicapryl phosphoric ester, dilauryl phosphoric ester, dimyristyl phosphoric ester, dicetyl phosphoric ester, distearyl phosphoric ester, tetraethyleneglycol mononeopentyl ether diphosphoric ester, triethyleneglycol monotridecyl ether diphosphoric ester, tetraethyleneglycol monolauryl ether diphosphoric ester and diethyleneglycol monostearyl ether diphosphoric ester and amine salts of these phosphoric esters. Examples of an amine include ammonia, monomethylamine, monoethylamine, monopropylamine, monobutylamine, dimethylamine, diethylamine, dipropylamine, dibutylamine, trimethylamine, triethylamine, tripropylamine, tributylamine, monoethanolamine, diethanolamine and triethanolamine.

Examples of a cyclization catalyst include aliphatic tertiary amines such as trimethylamine and triethylenediamine; aromatic tertiary amines such as dimethylaniline; and heterocyclic tertiary amines such as isoquinoline, pyridine, $\alpha$-picoline and $\beta$-picoline.

Examples of a dehydrating agent include aliphatic carboxylic anhydrides such as acetic anhydride, propionic anhydride and butyric anhydride; and aromatic carboxylic anhyrides such as benzoic anhydride.

Examples of inorganic fine particles include inorganic oxide powders such as fine-particulate titanium dioxide powder, silicon dioxide (silica) powder, magnesium oxide powder, aluminum oxide (alumina) powder and zinc oxide powder; inorganic nitride powders such as fine-particulate silicon nitride powder and titanium nitride powder; inorganic carbide powders such as silicon carbide powder; and inorganic salt powders such as fine-particulate calcium carbonate powder, calcium sulfate powder and barium sulfate powder. These inorganic fine particles may be used in combination of two or more. For homogeneously dispersing these inorganic fine particles, a means known per se can be applied.

<Production of a self-supporting film from a polyamic acid solution (b)>

A self-supporting film from a polyamic acid solution (b) is produced by applying a polyamic acid solution (b) on a support by flow casting and then heating it to such an extent that it becomes self-supporting state (it means it is in a stage before a usual curing process), for example, heating to such an extent that it can be peeled from the support. There are no particular restrictions to a solid concentration of the polyamic acid solution (b) as long as a viscosity is within the range suitable for the production, but generally, it is preferably 5 to 40 % by mass, further preferably 6 to 35 % by mass, particularly preferably 10 to 30 % by mass.

A temperature and a duration of heating in producing a self-supporting film is determined as appropriate. For thermal imidization, heating is conducted, for example, at a temperature of 100 to 180 °C for about 1 to 60 min.

There are no particular restrictions to a support as long as a polyamic acid solution can be cast on it, but it is preferably a smooth substrate; for example, a metal (for example, stainless steel) drum or belt.

There are no particular restrictions to the self-supporting film as long as a solvent has been removed such that the film can be peeled from a support and/or it is imidized, but in thermal imidization, a weight-loss-after-heating is preferably within the range of 20 to 50 % by mass and when a weight-loss-after-heating is within the range of 20 to 50 % by mass and an imidization rate is within the range of 7 to 55 %, a self-supporting film has satisfactory dynamic properties. Furthermore, a weight-loss-after-heating and an imidization rate in a self-supporting film within the above ranges are preferable because a coating solution can be uniformly and smoothly applied to the surface of the self-supporting film and no defects such as blisters, tears, crazes, cracks and fissures are observed in a polyimide film after imidization.

Here, a weight-loss-after-heating of a self-supporting film is determined in accordance with the following equation from a mass of the self-supporting film (W1) and the mass of a cured film (W2).

$$\text{Weight-loss-after-heating (\% by mass)} = \{(W1-W2)/W1\} \times 100$$

An imidization rate of the partially imidized self-supporting film is calculated by taking IR spectra of the self-supporting film and its fully-cured product (polyimide film) by the ATR method and determining an area or height of a vibrational band peak. A vibrational band peak employed can be, for example, a symmetric stretching vibration band of an imidocarbonyl group or a stretching vibration band of a benzene ring. More specifically, FT-IR spectra of a self-supporting film and its fully-cured film (polyimide film) were taken by the multireflection ATR method with Ge crystal and an incident angle of 45 ° using FT/IR6100 from JASCO Corporation, and an imidization rate was calculated in accordance with the following equation (1) using a ratio of a peak height of asymmetric stretching vibration of imidocarbonyl group at 1775 $cm^{-1}$ to a peak height of carbon-carbon symmetric stretching vibration of an aromatic ring at 1515 $cm^{-1}$.

$$\text{Imidization rate (\%)} = \{(X1/X2)/(Y1/Y2)\} \times 100 \quad (1)$$

wherein

X1: peak height of a self-supporting film at 1775 $cm^{-1}$,
X2: peak height of a self-supporting film at 1515 $cm^{-1}$,
Y1: peak height of a fully-cured film at 1775 $cm^{-1}$,
Y2: peak height of a fully-cured film at 1515 $cm^{-1}$.

<Coating of a polymer solution (a)>

Next, a polymer solution (a) (a polyamic acid solution (a) or a polyimide solution (a)) is applied on one side or both sides of the self-supporting film produced as described above.

The polymer solution (a) may contain, besides a polymer component, other additives as long as the characteristics of the present invention are not deteriorated by them; for example, surface treatment agents such as silane coupling agents and titanium coupling agents and surfactants such as silicone-based, fluorochemical-based and hydrocarbon-based surfactants. Such a surfactant is preferably decomposed or evaporated during the heating step for imidization.

A rotational viscosity (a solution viscosity measured by a rotationary viscometer at a measurement temperature of 25 °C) of a polymer solution (a) is in a range allowing the solution to be applied to a self-supporting film, preferably 0.5 to 50000 centipoise (mPa ·s). A solid concentration of a polymer solution (a) is preferably 1 to 15 % by mass, more preferably 2 to 8 % by mass. A monomer concentration may be adjusted such that such a concentration is substantially obtained during polymerization or alternatively a polymerization solution with a high solid concentration may be appropriately diluted before use.

In a process where a multilayer liquid film is formed by flow-casting on a support as described above, a total monomer concentration in an organic polar solvent is preferably higher than in the process involving coating.

The coating amount of the polymer solution (a) may be appropriately determined. Particular, it is preferably determined such that a preferable thickness of the polyimide layer (a) described above is obtained.

The polymer solution (a) is applied to the self-supporting film by a known method such as gravure coating, spin coating, silk screen printing, dip coating, spray coating, bar coating, knife coating, roll coating, blade coating and die coating.

<Heating (imidization) step>

Subsequently, the self-supporting film formed by applying the polymer solution (a) is heated to give a polyimide film. For giving a film exhibiting excellent adhesiveness, the heating is conducted such that the maximum temperature is preferably 350 °C or higher, preferably 370 °C or higher, more preferably 450 °C or higher, further preferably 470 °C or higher, particularly preferably 490 °C or higher. There are no particular restrictions to the upper limit of the heating temperature as long as the properties of a polyimide film are not deteriorated; the temperature is preferably 600 °C or lower, more preferably 590 °C or lower, further preferably 550 °C or lower, further preferably 540 °C or lower, further preferably 530 °C or lower, most preferably 520 °C or lower.

Suitably, heating is first conducted at a temperature of about 100 °C to 400 °C for gradually imidizing the polymer and evaporating/removing the solvent over about 0.05 to 5 hours, particularly 0.1 to 3 hours. Particularly, the heating is preferably conducted stepwise, that is, the first heating at a relatively lower temperature of about 100 °C to about 170 °C for about 0.5 to 30 min, then the second heating at a temperature of higher than 170 °C and 220 °C or lower for about 0.5 to 30 min, and then the third heating at an elevated temperature of higher than 220 °C and lower than 350 °C for about 0.5 to 30 min. Finally, as described above, it is preferable to conduct the fourth heating at a high temperature of 350 °C or higher. The heating process can be conducted sequentially or continuously.

In the above production process, the film on the support or a film after being peeled from the support can be heated.

In heating for imidization in industrial production, a long self-supporting film is fixed at least at both edges in a direction perpendicular to its longitudinal direction, that is, in a width direction of the film by a fixing means such as pin tenters, clips and a frame in a cure furnace while the film is, if necessary, extended or compacted either in a width direction or in a longitudinal direction.

Then, the surface with the applied polymer solution (a) of the polyimide film of the present invention produced as described above can be further processed by, for example, sandblasting, corona treatment, plasma treatment or

etching.

<Polyimide laminate>

The side of a polyimide film with an applied polymer solution (a) exhibits excellent adhesiveness to an adhesive. Thus, an adhesive layer can be directly formed in the side of a polyimide film with an applied polymer solution (a), which allows for producing a polyimide laminate exhibiting excellent initial peeling strength between the polyimide film and the adhesive layer, excellent peeling strength after treatment at a high temperature, in which peeling strength is less reduced or even improved.

The present invention, therefore, provides a polyimide laminate having a polyimide film containing a polyimide layer (a) constituting at least one surface layer and a polyimide layer (b) to be a base layer and an adhesive layer laminated in contact with the polyimide layer (a).

There are no particular restrictions to a laminated adhesive as long as it is a heat resistant adhesive such as polyimide-based, epoxy-based, acryl-based, polyamide-based and urethane-based adhesives which are used in the electric and the electronic fields, and it may be a heat resistance adhesive such as polyimide-based adhesives, epoxy-modified polyimide-based adhesives, phenol-modified epoxy resin adhesives, epoxy-modified acryl resin-based adhesives and epoxy-modified polyamide-based adhesives.

An adhesive can be applied by any method which is used in the electronic field; for example, an adhesive solution can be applied on the side to which a polymer solution (a) is to be applied in the polyimide film and then dried, or alternatively a separately formed adhesive film can be applied.

The polyimide laminate can be further laminated with another substrate such as a glass substrate, a ceramic such as silicon wafer, a metal foil, a resin film and a woven or unwoven fabric of carbon fiber, glass fiber and resin fiber via the adhesive layer. The other substrate can be directly laminated with the adhesive layer of the polyimide laminate using a compression machine or heating/compression machine.

The other substrate is preferably a metal foil which can be an elemental metal or alloy; for example, a metal foil of copper, aluminum, gold, silver, nickel and stainless steel, suitably copper foils such as rolled copper foil and electrolytic copper foil. A thickness of a metal foil is, but not limited to, preferably 0.1 μm to 10 mm, particularly preferably 7 to 60 μm.

When an ultrathin substrate (metal foil) with a thickness of 1 to 10 μm is used, a metal foil having a carrier formed of a metal or resin may be used for improving handling.

The present invention, therefore, provides a laminate containing a polyimide film having a polyimide layer (a) and a polyimide layer (b) as described above, an adhesive layer formed on the surface of the polyimide layer (a), and another substrate laminated via the adhesive layer, particularly preferably a polyimide-metal laminate having, as the other substrate, a metal foil.

A compression machine or a heating/compression machine used for lamination can be a pair of compression-bonding metal rolls (a compression-bonding part is made of a metal or ceramic-sprayed metal), a double belt press or a hot press. Particularly preferred is that which can perform thermal compression-bonding and cooling while applying pressure and among others particularly a hydraulic double-belt press.

The side of a polyimide film to which a polymer solution (a) is applied exhibits good adhesiveness and adherence, so that a photosensitive material, a thermally compression-bondable material or the like can be directly laminated on it.

<Polyimide-metal laminate (direct formation of a metal layer)>

A polyimide film of this aspect is also excellent in adherence to a metal layer. Thus, a metal layer can be directly (that is, by plating without an intervening adhesive layer) formed on the side of a polyimide film to which a polymer solution (a) is applied, to give a polylmide-metal laminate exhibiting excellent peeling strength, that is, excellent initial peeling strength between a polyimide film and a metal layer, excellent peeling strength after treatment at a high temperature, in which peeling strength is less reduced or a peeling strength after treatment at a high temperature becomes higher than initial peeling strength.

For this purpose, the heating (imidization) is conducted such that the maximum temperature is preferably 450 °C or higher, more preferably 470 °C or higher.

This polyimide-metal laminate preferably has such excellent adherence that in addition to at the initial stage, peeling strength is not reduced after heating at 150 °C or at 121 °C, 0.2 MPa and 100 % RH.

Therefore, the present invention further provides a polyimide-metal laminate comprising a polyimide film including a polyimide layer (a) and a polyimide layer (b) and a metal layer laminated on the surface of the polyimide layer (a).

A metal layer can be formed on the surface of a polyimide layer (a) by plating. The plating method includes metalizing which is a dry plating method or wet plating method. Herein, metalizing method is, unlike wet plating method or metal foil lamination, a method for forming a metal layer by vapor-phase deposition, the examples of which include

known methods such as vacuum deposition, sputtering, ion plating and electron beam.

Examples of a metal used in metalizing include, but not limited to, metals such as copper, nickel, chromium, manganese, aluminum, iron, molybdenum, cobalt, tungsten, vanadium, titanium and tantalum; alloys of these; oxides of these metals; and carbides of these metals. A thickness of a metal layer formed by metalizing is appropriately selected depending on its application, and is preferably in the range of 1 to 1000 nm, further preferably in the range of 5 nm to 500 nm in the light of suitability for practical use.

The number of metal layers formed by metalizing can be appropriately selected depending on its intended use, and it may be one two, three or more layers. In an embodiment where a metal layer is formed in multilayers, it is preferable that by metalizing, the first layer (a layer directly contacting a polyimide film) is formed from, for example, a metal such as nickel, chromium, manganese, aluminum, iron, molybdenum, cobalt, tungsten, vanadium, titanium and tantalum, alloys of these, an oxide of these metal or a carbide of these metal, and the second layer is formed from, for example, copper or a copper alloy, an oxide of these metal or a carbide of these metal. On the second layer, further a metal (for example, copper) layer with a thickness of about 1 to 40 $\mu$m may be formed by wet plating.

When wet plating is employed for forming a metal layer on a polyimide film of this aspect, a known plating method can be used, such as electrolytic plating, electroless plating or a combination of these. A metal used for wet plating may be any metal with no particular restrictions as long as it can be wet-plated.

A thickness of a metal layer formed by wet plating can be appropriately selected depending on its intended use, and it is preferably in the range of 0.1 to 50 $\mu$m, further preferably 1 to 30 $\mu$m in the light of suitability for practical use. The number of metal layers formed by wet plating can be appropriately selected depending on its intended use, and it may be one, two, three or more layers.

There is no particular restrictions to the wet plating method, and it may be any known wet-plating process, the examples of which include known methods such as performing electroless copper plating after ELFSEED process (Ebara-Udylite Co., Ltd.) or CATALYST BOND process (Nippon Mining & Metals Corporation) as a surface treatment process.

ELFSEED process (Ebara-Udylite Co., Ltd.) is a process where a polyimide film surface is modified, catalyzed, reduced and then subjected to electroless nickel plating and further electroless nickel plated film is activated. After the process, electrolytic copper plating is conducted to give a conductive metal layer.

CATALYST BOND process (Nippon Mining & Metals Corporation) is a pre-treatment process before plating. The pre-treatment can improve adsorbability of palladium as a wet plating catalyst. After the process, the catalyst is added and the electroless and the electrolytic copper plating are conducted to give a conductive metal layer.

As described above, a polyimide film, a polyimide-metal laminate (including both a laminate where a film and a metal layer are laminated via an adhesive layer and a laminate where a metal layer is directly formed on a film) and a polyimide laminate illustrated as the first aspect may be used as a material for electronic components and an electronic devices including a printed-wiring board, a flexible printed board, a TAB tape, a COF tape or a metal wiring, or a cover substrate for a metal wiring and a chip member such as an IC chip and a base substrate for a liquid crystal display, an organic electroluminescence display, an electronic paper, a solar battery and the like.

A linear expansion coefficient of the polyimide film is appropriately selected depending on an intended use. For example, when it is used as a material for an insulating substrate for a FPC, a TAB, a COF and a metal wiring substrate and a cover substrate for a metal wiring or a chip member including an IC chip, in general the polyimide film preferably has a linear expansion coefficient close to a linear expansion coefficient of a metal wiring or a chip member including an IC chip. Specifically, both MD and TD are preferably 40 ppm/°C or less, more preferably 0 to 30 ppm/°C, further preferably 5 to 25 ppm/°C, particularly preferably 8 to 20 ppm/°C.

Furthermore, depending on a use such as a COF and an interposer, a linear expansion coefficient of a polyimide film is preferably close to a linear expansion coefficient of glass or silicon. According to the present invention, there can be also provided a polyimide film with a linear expansion coefficient of 0 to 10 ppm/°C.

The disclosure of the polyimide film, the polyimide laminate and the polyimide-metal laminate according to the first aspect is generally summarized as follows.

[1] A polyimide film produced by applying a polymer solution (a) capable of giving a polyimide layer (a) to one side or both sides of a self-supporting film formed from a polyamic acid solution (b) capable of giving a polyimide layer (b) and heating the self-supporting film,
wherein the polyimide layer (a) is a polyimide produced from a tetracarboxylic dianhydride component and a diamine component containing a diamine compound represented by formula (1).

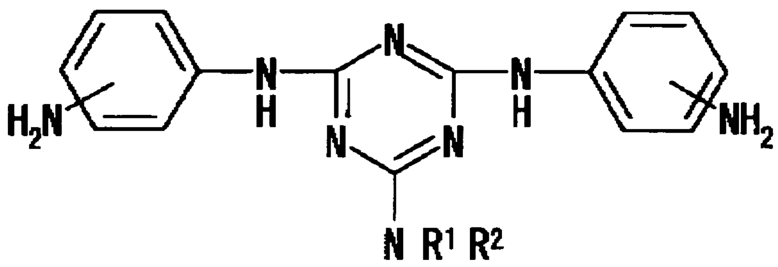

(1)

wherein $R^1$ denotes a hydrogen atom, an alkyl group having 1 to 12 (for example, 1 to 10) carbon atoms or an aryl group and $R^2$ denotes an alkyl group having 1 to 12 (for example 1 to 10) carbon atoms or an aryl group.

[2] The polyimide film according to the above item [1], wherein the diamine compound represented by formula (1) is 2,4-bis(4-aminoanilino)-6-anilino-1,3,5-triazine.

[3] The polyimide film according to the above item [1] or [2], wherein for the polyimide layer (a), the diamine component contains the diamine compound represented by formula (1) in 10 to 100 mol%.

[4] The polyimide film according to the above item [1] or [2], wherein for the polyimide layer (a), the diamine component comprises the diamine compound represented by formula (1) in a range of 25 to 100 mol%.

[5] The polyimide film according to any one of the above items [1] to [4], wherein for the polyimide film, a maximum heating temperature is 350 °C or higher.

[6] The polyimide film according to any one of the above items [1] to [4], wherein for the polyimide film, a maximum heating temperature is 450 °C or higher.

[7] The polyimide film according to any one of the above items [1] to [6], wherein for the polyimide layer (a), the diamine component further comprises phenylene diamine and/or diaminodiphenyl ether.

[8] The polyimide film according to any one of the above items [1] to [7], wherein the polyimide film is used for an application where an adhesive layer is directly laminated on the surface of the polyimide layer (a) obtained by applying the polyamic acid solution (a).

[9] The polyimide film according to any one of the above items [1] to [8], wherein polyimide layer (b) is a polyimide produced from a tetracarboxylic dianhydride component comprises 3,3',4,4'-biphenyltetracarboxylic dianhydride and/or pyromellitic dianhydride and a diamine component comprises phenylene diamine and/or diaminodiphenyl ether.

[10] The polyimide film according to any one of the above items [1] to [9], wherein the polymer solution (a) capable of giving the polyimide layer (a) is a polyamic acid solution (a) capable of giving a polyimide layer (a).

[11] A polyimide laminate wherein an adhesive layer is directly laminated on the coating surface of the polyimide film according to any one of the above items [1] to [10].

[12] A polyimide-metal laminate wherein a metal layer is laminated on the coating surface of the polyimide film according to any one of the above items [1] to [10] via an adhesive layer.

[13] A polyimide-metal laminate having a metal layer formed by dry or wet plating on the surface of the polyimide layer (a) in the polyimide film according to any one of the above items [1] to [10].

<<Part 2>>

There will be described the second aspect of the present invention. The second aspect is a polyimide film used for direct lamination with an adhesive layer, wherein a polyimide is produced by reacting a tetracarboxylic dianhydride component with a diamine component containing a diamine compound represented by formula (1) in a range of more than 0 to 100 mol%, preferably 5 to 100 mol%, further preferably 10 to 100 mol%.

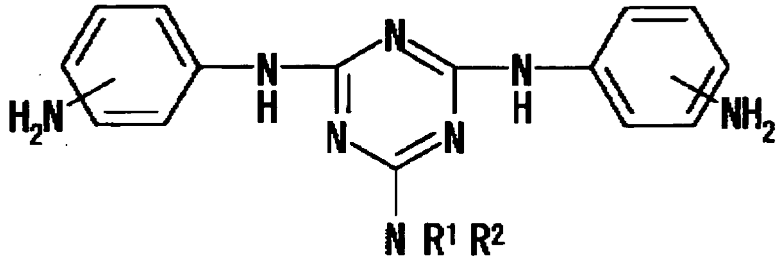

(1)

wherein $R^1$ denotes a hydrogen atom, an alkyl group having 1 to 12 carbon atoms or an aryl group, and $R^2$ denotes an alkyl group having 1 to 12 carbon atoms or an aryl group.

The polyimide film of this aspect corresponds to a film consisting of a single layer of a material constituting a polyimide layer (a) described in the first aspect (part 1). Unless otherwise stated, the description for part 1 is applied to this part as long as there is not discrepancy.

The second aspect of the present invention can provide a polyimide film exhibiting excellent adhesiveness to an adhesive, particularly even after heating.

This aspect can provide a laminate of a polyimide film with an adhesive exhibiting excellent peeling strength with an adhesive, particularly even after heating.

A polyimide film of this aspect is produced by thermal imidization and/or chemical imidization, and when a plurality of tetracarboxylic acid components and diamine components are involved, random copolymerization or block copolymerization or a combination of these can be employed.

A thickness of a polyimide film is, but not limited to, generally 5 to 120 μm, preferably 6 to 75 μm, further preferably 7 to 60 μm.

Examples of a process for manufacturing a polyimide film of this aspect generally include

(1) a process comprising flow-casting, on a support in a form of film, a polyamic acid solution or a polyamic acid solution composition containing, as necessary, additives selected from an imidization catalyst, a dehydrating agent, a release assisting agent and inorganic fine particles in a polyamic acid solution, drying the film by heating to give a self-supporting film, and then heating it for cyclodehydration and for removal a solvent to give a polyimide film.

(2) a process comprising flow-casting, on a support in a form of film, a polyamic acid solution composition prepared by adding a cyclization catalyst and a dehydrating agent and a further selected additive, as necessary, such as inorganic fine particles to a polyamic acid solution; then chemically cyclodehydrating it and, as necessary, drying it by heating to give a self-supporting film, which is then heated for removing a solvent and imidization to give a polyimide film.

(3) when a polyimide is soluble in an organic solvent, a process comprising flow-casting, on a support in a form of film, a polyimide solution composition containing selected additives such as a release assisting agent and inorganic fine particles, drying by heating it to partially or completely remove a solvent, and then heating it to a maximum heating temperature to give a polyimide film.

(4) when a polyimide is soluble in an organic solvent, a process for producing a polyimide film by flow-casting, on a support in a form of film, a polyimide solution composition containing selected additives such as a release assisting agent and inorganic fine particles, heating the film to a maximum heating temperature while a solvent is removed, to give a polyimide film.

In the above production processes, the heating after forming a self-supporting film is conducted at such a temperature that a maximum heating temperature is 350 °C or higher, further 450 °C or higher, to improve peeling strength after the heating.

In the heating at a maximum heating temperature in the above production processes, the film may be heated on the support or heated after being peeled from the support.

The polyimide film is preferably produced from a polyamic acid.

There will be described production processes with starting materials for the polyimide.

<Tetracarboxylic acid component and diamine component>

There will be described a tetracarboxylic acid component and a diamine component used in production of a polyimide film of the second aspect.

A tetracarboxylic acid component used herein is a tetracarboxylic acid component used for the polyimide layer (a) in the first aspect described in Part 1 (that is, identical to the tetracarboxylic acid used for the polyimide layer (b)). Furthermore, a preferred one is also identical to that for the polyimide layer (a).

A diamine component used herein is also a diamine component used for the polyimide layer (a) in Part 1. Furthermore, a preferred one is also identical to that for the polyimide layer (a).

The diamine component may contain a diamine component other than the diamine represented by general formula (1). Examples of the co-component diamine include the diamine component used for the polyimide layer (b) in the first aspect as in a polyimide layer (a) of the first aspect; preferably a diamine component selected from PPD and diaminodiphenyl ethers, more preferably a diamine component containing one or more selected from PPD, 4,4'-diaminodiphenyl ether and 3,4'-diaminodiphenyl ether. The polyimide film therefrom exhibits excellent mechanical properties and thermal properties.

A polyimide layer (a) is preferably, inter alia, a polyimide obtained from a polyamic acid prepared from an acid

component containing s-BPDA and PMDA, a diamine represented by general formula (1) or a diamine represented by general formula (1) and PPD or a diaminodiphenyl ether such as 4,4'-diaminodiphenyl ether and 3,4'-diaminodiphenyl ether.

A polyimide of the present invention is preferably free from at least one proton-conducting functional group selected from the group consisting of $-SO_3H$, -COOH and $PO_3H_2$ as described in Patent Document 3, for excellent heat resistance.

In this aspect, a diamine compound represented by formula (1) is contained in a range of more than 0 to 100 mol%, preferably 5 to 100 mol%, further preferably 10 to 100 mol%, preferably 15 to 100 mol%, more preferably 17 to 100 mol% based on the total the diamine component (=100 mol%). In a particular embodiment, it is also preferably used in the amount of 25 to 100 mol%.

In the light of heat resistance based on a 5 % weight loss temperature of a film, the diamine compound represented by formula (1) is contained in the diamine component preferably in a range of 10 to 50 mol%, further preferably 15 to 40 mol%, particularly preferably 17 to 30 mol%.

<Preparation of a polyamic acid solution or polyimide solution>

A polyamic acid (polyimide precursor) is produced by reacting a tetracarboxylic acid component and a diamine component in a known manner using the components described above; for example, substantially equimolar components may be reacted in an organic solvent to give a solution of a polyamic acid (partial imidization may be allowed to take place if the solution is maintained in homogeneous state). Alternatively, two or more polyamic acids in which one of the components is relatively excessively contained are preliminarily synthesized, and these polyamic acid solutions can be combined and mixed under the reaction conditions. The polyamic acid solution thus prepared can be used for production of a self-supporting film as it is or, as necessary, after removing or adding a solvent.

When a polyimide obtained is soluble in an organic solvent, the polyimide can be obtained by reacting a tetracarboxylic acid component and a diamine component in a known manner using the components described above; for example, a polyimide solution can be produced by reacting substantially equimolar components in an organic solvent. Alternatively, two or more polyimides in which one of the components is relatively excessively contained are preliminarily synthesized, and these polyimide solutions can be combined and mixed under the reaction conditions.

An organic solvent used herein for the polyamic acid solution or polyimide solution can be a known solvent such as N-methyl-2-pyrrolidone, N,N-dimethylformamide, N,N-dimethylacetamide and N,N-diethylacetamide. These organic solvents are used alone or in combination of two or more.

In the polymerization reaction of a polyamic acid and a polyimide, a concentration of the total monomers in an organic polar solvent can be appropriately selected depending on an intended use; for example, a concentration of the total monomers in an organic polar solvent is preferably 10 % by mass to 30 % by mass, further preferably 15 % by mass to 27 % by mass, particularly preferably 18 % by mass to 26 % by mass.

As an example of a process for preparing a polyamic acid, the above polymerization reaction of an aromatic tetracarboxylic acid component and an aromatic diamine component is conducted, for example, by mixing them in substantially equimolar amounts or in amounts such that one of them is slightly in excess of the other component (the acid component or the diamine component) and reacting them at a reaction temperature of 100 °C or lower, preferably 80 °C or lower for about 0.2 to 60 hours to give a polyamic acid solution.

As an example of a process for preparing a polyimide, the above polymerization reaction of an aromatic tetracarboxylic acid component and an aromatic diamine component is conducted, for example, by mixing them in substantially equimolar amounts or in amounts such that one of them is slightly in excess of the other component (the acid component or the diamine component) and processed by a known method to give a polyimide solution; for example, the mixture can be reacted at a reaction temperature of 140 °C or higher, preferably 160 °C or higher (preferably 250 °C or lower, further preferably 230 °C or lower) for about 1 to 60 hours to give a polyimide solution.

For thermal imidization, the polyamic acid solution may contain, as necessary, an imidization catalyst, an organic phosphorous-containing compound, inorganic fine particles or the like. For chemical imidization, the polyamic acid solution may contain, as necessary, a cyclization catalyst, a dehydrating agent, inorganic fine particles or the like. The polyimide solution may contain an organic phosphorous-containing compound, inorganic fine particles or the like.

Herein, an imidization catalyst, an organic phosphorous-containing compound, a cyclization catalyst, a dehydrating agent and inorganic fine particles as described in Part 1 may be used. Furthermore, inorganic fine particles may be replaced by polyimide fine particles insoluble in an organic solvent.

<Production of a self-supporting film from a polyamic acid solution>

A self-supporting film from a polyamic acid solution is produced by applying a polyamic acid solution on a support by flow casting and then heating it to such an extent that it becomes self-supporting state (it means it is in a

stage before a usual curing process), for example, heating to such an extent that it can be peeled from the support.

There are no particular restrictions to a solid concentration of the polyamic acid solution used in the present invention as long as a viscosity is within the range suitable for the production, but generally, it is preferably 10 % by mass to 30 % by mass, more preferably 15 % by mass to 27 % by mass, further preferably 18 % by mass to 26 % by mass.

The other conditions in producing a self-supporting film are as described in the section "Production of a self-supporting film from a polyamic acid solution (b)" in Part 1.

In producing a polyimide film from a polyimide solution, an applied film may be heated at a maximum heating temperature in the subsequent heating process not via a self-supporting film or without peeling it from a support as described above.

<Heating (imidization) process>

Subsequently, the self-supporting film is heated to give a polyimide film. The heating is conducted such that the maximum temperature is preferably 350 °C or higher, more preferably 450 °C or higher, further preferably 470 °C or higher. There are no particular restrictions to the upper limit of the heating temperature as long as the properties of a polyimide film are not deteriorated; the temperature is preferably 600 °C or lower, more preferably 550 °C or lower, further preferably 530 °C or lower, most preferably 520 °C or lower.

Suitably, heating is first conducted at a temperature of about 100 °C to lower than 350 °C for gradually imidizing the polymer and evaporating/removing the solvent over about 0.05 to 5 hours, particularly 0.1 to 3 hours. Particularly, the heating is preferably conducted stepwise, that is, the first heating at a relatively lower temperature of about 100 °C to about 170 °C for about 0.5 to 30 min, then the second heating at a temperature of higher than 170 °C and 220 °C or lower for about 0.5 to 30 min, then the third heating at an elevated temperature of higher than 220 °C and lower than 350 °C for about 0.5 to 30 min, and furthermore, as a requisite step, the fourth heating at a high temperature of 350 °C or higher and 600 °C or lower. The heating process can be conducted sequentially or continuously.

In heating in industrial production, a long self-supporting film is fixed at least at both edges in a direction perpendicular to its longitudinal direction, that is, in a width direction of the film by a fixing means such as pin tenters, clips and a frame in a cure furnace while the film is, if necessary, extended or compacted either in a width direction or in a longitudinal direction.

Then, the polyimide film of the present invention produced as described above can be further processed by, for example, sandblasting, corona treatment, plasma treatment or etching.

For a polyimide film thus produced of the present invention, when a concentration of the diamine represented by general formula (1) in the total diamine components is high (for example, 30 % by mass or higher), a thick polyimide film is preferable (for example, 25 μm or more) in comparison with a thin one for obtaining a polyimide film having good film appearance.

When a tetracarboxylic acid component is PMDA and a concentration of the diamine represented by general formula (1) in the total diamine components is high (for example, 80 % by mass or higher), a lower maximum heating temperature in the heating (imidization) process (for example, 300 to 400 °C) is preferable for obtaining a polyimide film having good film appearance.

<Polyimide film laminate>

The surface of the polyimide film exhibits excellent adhesiveness to an adhesive. Therefore, as described for the polyimide film of the first aspect (described in Part 1), a polyimide film of the second aspect can be used to give a polyimide laminate on which an adhesive layer is laminated and that another substrate is additionally laminated.

The present invention, therefore, provides a polyimide laminate containing the polyimide film described above for the second aspect and an adhesive layer formed contacting the polyimide film.

The present invention further provides a laminate containing the polyimide film described above for the second aspect, an adhesive layer formed contacting the polyimide film and another substrate laminated via the adhesive layer, particularly preferably a polyimide-metal laminate on which a metal foil is laminated as another substrate.

A linear expansion coefficient of a polyimide film of the second aspect is also as described for the first aspect.

The disclosure of the second aspect is generally summarized as follows.

[1] A polyimide film used for direct lamination with an adhesive layer, wherein a polyimide constituting the polyimide film is produced by reacting a tetracarboxylic dianhydride component with a diamine component containing a diamine compound represented by formula (1) in a range of more than 0 to 100 mol%, preferably 5 to 100 mol%, further preferably 10 to 100 mol%.

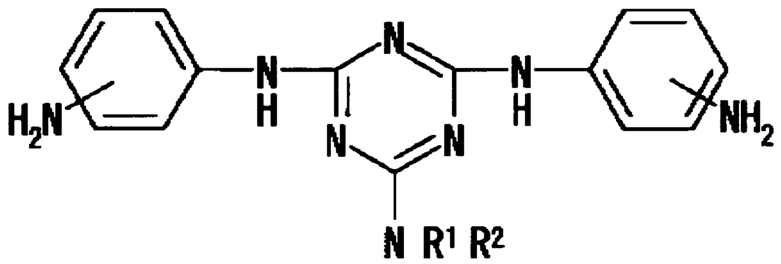

(1)

wherein $R^1$ denotes a hydrogen atom, an alkyl group having 1 to 12 carbon atoms or an aryl group, and $R^2$ denotes an alkyl group having 1 to 12 carbon atoms or an aryl group.

[2] The polyimide film according to the above item [1], wherein the diamine compound represented by formula (1) is 2,4-bis(4-aminoanilino)-6-anilino-1,3,5-triazine.

[3] The polyimide film according to the above item [1] or [2], produced by a method comprising a heating step in which a maximum heating temperature is 350 °C or higher.

[4] The polyimide film according to the above item [1] or [2], produced by a method comprising a heating step in which a maximum heating temperature is 450 °C or higher.

[5] The polyimide film according to any one of the above items [1] to [4], wherein the diamine component further contains phenylene diamine or diaminodiphenyl ether.

[6] The polyimide film according to any one of the above items [1] to [5], wherein the tetracarboxylic dianhydride component contains 3,3',4,4'-biphenyltetracarboxylic dianhydride and/or pyromellitic dianhydride.

[7] A polyimide laminate containing the polyimide film according to any one of the above items [1] to [6] and an adhesive layer formed directly contacting the polyimide film.

[8] A laminate containing the polyimide film according to any one of the above items [1] to [6], an adhesive layer formed directly contacting the polyimide film and another substrate laminated via the adhesive layer; particularly preferably a polyimide-metal laminate containing a metal foil as another substrate.

<<Part 3>>

There will be described the third aspect of the present invention. The third aspect relates to a polyimide film used for forming a metal layer on a film surface by plating. Although there has been described that a polyimide film of the first aspect is suitable for forming a metal layer by dry or wet plating, a polyimide film of the third aspect is also suitable for this application.

A polyimide film according to the third aspect is a multilayer film like the polyimide film described for the first aspect. Furthermore, a polyimide film according to the third aspect is a single-layer film like the polyimide film described for the second aspect.

There will be described a single-layer film. This aspect relates to a polyimide film wherein the polyimide is produced by reacting a tetracarboxylic dianhydride component with a diamine component containing a diamine compound represented by formula (1) in a range of 10 to 100 mol%. A polyimide film is preferably produced by heating under such conditions that a maximum heating temperature is 450 °C or higher in the heating process.

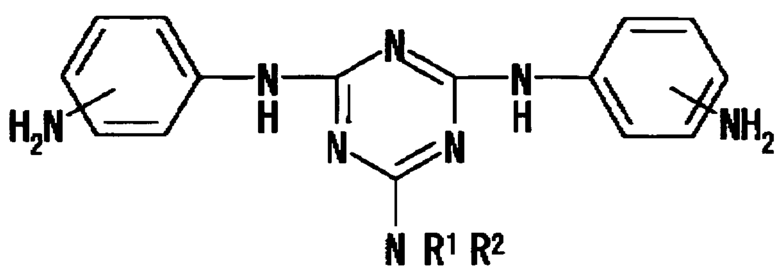

(1)

wherein $R^1$ denotes a hydrogen atom, an alkyl group having 1 to 12 carbon atoms or an aryl group, and $R^2$ denotes an alkyl group having 1 to 12 carbon atoms or an aryl group.

According to the third aspect of the present invention where a metal layer is formed by plating, there can be provided a polyimide film having excellent adherence which is kept high, not only in the initial stage, such that peeling strength is not reduced after heating at 150 °C or at 121 °C, 0.2 MPa and 100 % RH.

Furthermore, there can be provided a polyimide-metal laminate having a metal layer formed by plating which has such excellent adherence that in addition to at the initial stage, peeling strength is not reduced after heating at 150 °C or at 121 °C, 0.2 MPa and 100 % RH.

When a polyimide film is a film which is a single polyimide layer, the starting materials for a polyimide and a procedure until production of a self-supporting film are as described for the second aspect. There will be described, therefore, only a heating process.

<Heating (imidization) process>

In the third aspect, a self-supporting film produced is heated in a heating process where a maximum heating temperature is preferably 450 °C or higher, more preferably 470 °C or higher to give a polyimide film. There are no particular restrictions to the upper limit of a heating temperature as long as the properties of a polyimide film are not deteriorated; the temperature is preferably 600 °C or lower, more preferably 550 °C or lower, further preferably 530 °C or lower, most preferably 520 °C or lower.

Suitably, heating, which can be conducted stepwise, is first conducted at a temperature of about 100 °C to 400 °C for gradually imidizing the polymer and evaporating/removing the solvent over about 0.05 to 5 hours, particularly 0.1 to 3 hours. Particularly, the heating is preferably conducted stepwise, that is, the first heating at a relatively lower temperature of about 100 °C to about 170 °C for about 0.5 to 30 min, then the second heating at a temperature of higher than 170 °C and 220 °C or lower for about 0.5 to 30 min, then the third heating at an elevated temperature of higher than 220 °C and lower than 450 °C for about 0.5 to 30 min, and furthermore, as a requisite step, heating at a maximum temperature of 450 °C to 550 °C, preferably 470 to 530 °C, further preferably 480 to 520 °C. The heating process can be conducted sequentially or continuously.

In heating in industrial production, a long self-supporting film is fixed at least at both edges in a direction perpendicular to its longitudinal direction, that is, in a width direction of the film by a fixing means such as pin tenters, clips and a frame in a cure furnace while the film is, if necessary, extended or compacted either in a width direction or in a longitudinal direction.

A polyimide film of the present invention has a thickness of, but not limited to, about 3 to 250 μm, preferably about 4 to 150 μm, more preferably about 5 to 125 μm, further preferably about 5 to 100 μm.

The polyimide film of the present invention can be further processed by, for example, sandblasting, corona treatment, plasma treatment or etching.

<Process for forming a polyimide-metal laminate and a metal layer>

A polyimide film of this aspect exhibits excellent adherence to a metal layer, so that a metal layer can be formed on its surface to give a polyimide-metal laminate. When a polyimide film of this aspect is used, a side to be plated can be either side A or side B.

A metal layer can be formed by plating such as metalizing as a dry plating method and wet plating.

Wet plating and metalizing have been detailed in the section "Polyimide-metal laminate (direct formation of a metal layer)" in Part 1, and can be conducted in accordance with the procedure described there (preferable conditions and materials are also identical).

The polyimide film and a polyimide-metal laminate thus produced can be used as an element for an electronic component or an electronic device such as a printed-wiring board, a flexible printed board, a TAB tape, a COF tape, a metal wiring or the like, or a cover substrate for a metal wiring or a chip member including an IC chip, and a base substrate for a liquid crystal display, an organic electroluminescence display, an electronic paper or a solar battery.

A linear expansion coefficient of the polyimide film is appropriately selected depending on an intended use. For example, when it is used as a material for an insulating substrate for an FPC, a TAB, a COF and a metal wiring substrate and a cover substrate for a metal wiring or a chip member including an IC chip, in general the polyimide film preferably has a linear expansion coefficient close to a linear expansion coefficient of a metal wiring or a chip member including an IC chip. Specifically, both MD and TD are preferably 40 ppm/°C or less, more preferably 0 to 30 ppm/°C, further preferably 5 to 25 ppm/°C, particularly preferably 8 to 20 ppm/°C.

The disclosure of the third aspect is generally summarized as follows.

[1] A Polyimide film for use in forming a metal layer on a polyimide surface by plating, wherein a polyimide constituting the polyimide film is produced by reacting a tetracarboxylic dianhydride component and a diamine component containing a diamine compound represented by formula (1) in a range of 10 to 100 mol% and wherein the polyimide film is obtained by heat treatment in a heating step under such conditions that a maximum heating temperature is 450 °C or higher.

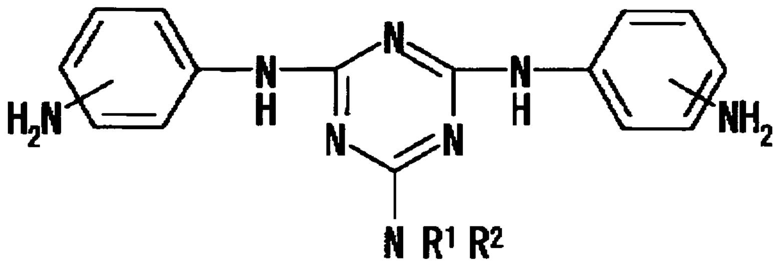 (1)

wherein $R^1$ denotes a hydrogen atom, an alkyl group having 1 to 12 carbon atoms or an aryl group, and $R^2$ denotes an alkyl group having 1 to 12 carbon atoms or an aryl group.

[2] The polyimide film according to the above item [1], wherein the diamine compound represented by general formula (1) is 2,4-bis(4-aminoanilino)-6-anilino-1,3,5-triazine.

[3] The polyimide film according to the above item [1] or [2], wherein in the polyimide, the diamine component further contains phenylene diamine or diaminodiphenyl ether.

[4] The polyimide film according to any one of the above items [1] to [3], wherein the tetracarboxylic dianhydride component is a tetracarboxylic dianhydride component containing 3,3',4,4'-biphenyltetracarboxylic dianhydride and/or pyromellitic dianhydride.

[5] The polyimide film according to any one of the above items [1] to [4], wherein the plating is dry or wet plating.

[6] A polyimide-metal laminate containing the polyimide film according to any one of the above items [1] to [5] and a metal layer formed by plating.

## EXAMPLES

There will be further detailed the present invention with reference to, but not limited to, Examples.

<Evaluation method>

Physical properties of a polyimide film were evaluated in accordance with the following methods.

a) A peeling strength is a peeling strength at 90 ° peeling and determined at a peeling speed of 50 mm/min under the atmosphere of a temperature of 23 °C and a humidity of 50 %.

b) As for the surface of the polyimide film, the air side when the polyamic acid solution was cast on the support was taken as Side A, while the support side was taken as Side B.

c) In the column of a peeling strength of a polyimide laminate and a polyimide-metal laminate in the table, peeling mode between a polyimide and an bonded material is observed and the results are shown in the table as the following 1) to 4). A level of peeling mode was determined as the order "2)>1)>4)>3)".

1) Combination of interfacial peeling of a polyimide/an adhesive (an adhesive is turbid) and cohesion failure of an adhesive.
2) Cohesion failure of an adhesive.
3) Interfacial peeling of a polyimide/an adhesive.
4) Turbidity of an adhesive in interfacial peeling of a polyimide/an adhesive.

(1) Measurement of a peeling strength of a polyimide laminate A (coverlay)

- Production of a polyimide laminate A

On a surface of a polyimide film for which adhesiveness was to be evaluated (in Example Part I, a polyamic-acid-solution coating surface) was laminated a coverlay CVA0525KA (from Arisawa Manufacturing Co., Ltd.) by pressing at 180 °C and 3 MPa for 30 min to give a polyimide laminate A.

- Measurement of a peeling strength

A peeling strength for the polyimide laminate A was determined as an initial peeling strength A. The polyimide laminate A was treated in a hot-air drying machine at 150 °C for 24 hours, and then a peeling strength was determined as a post-heating peeling strength A.

(2) Measurement of a peeling strength of a polyimide-metal laminate (wet plating)

- Production of a polyimide-metal laminate

On a polyimide film surface, were sequentially formed a electroless nickel-plated layer by wet plating process (ELFSEED process; Ebara-Udylite Co., Ltd.) and an electrolytic copper-plated layer, and further heated at 65 °C for 30 min to give a polylmide-metal laminate with a copper thickness of 10 μm.

- Measurement of a peeling strength

A peeling strength for the polyimide-metal laminate was determined as an initial peeling strength A1.
The polyimide-metal laminate was treated in a hot-air drying machine at 150 °C for 24 hours, and then a peeling strength was determined as a post-heating peeling strength A2.
The polyimide-metal laminate was treated in a hot-air drying machine at 150 °C for 168 hours, and then a peeling strength was determined as a post-heating peeling strength A3.
A polyimide-metal laminate was treated under the atmosphere of 121 °C, 100 % RH and 0.2 MPa using a pressure cooker testing machine for 24 hours, and then a peeling strength was determined as a cooker peeling strength A4.
A polyimide-metal laminate was treated under the atmosphere of 121 °C, 100 % RH and 0.2 MPa using a pressure cooker testing machine for 96 hours, and then a peeling strength was determined as a cooker peeling strength A5.

(3) Measurement of a peeling strength of a polyimide-metal laminate (dry plating)

- Production of a polyimide-metal laminate

On a coating surface of a polyimide film, the first layer of a Ni/Cr (mass ratio: 8/2) layer with a thickness of 25 nm was formed by a common sputtering procedure. Then, on the first layer, the second layer of a copper layer with a thickness of 400 nm was formed. Then, on the copper layer, a copper-plated layer with a thickness of 20 μm was formed to give a polyimide-metal laminate.

- Measurement of a peeling strength

A peeling strength of a polyimide-metal laminate produced by dry plating was determined as described for determination of a peeling strength of a polyimide-metal laminate produced by wet plating.

<<Example Part I (Examples corresponding to Part 1)>>

<Preparation of a polyamic acid solution, a coating solution>

<u>Preparation of a polyamic acid solution I-A</u>

In a polymerization vessel were charged N,N-dimethylacetamide(DMAc) and paraphenylene diamine (PPD) as a diamine component in predetermined amounts, and to the mixture 3,3',4,4'-biphenyltetracarboxylic dianhydride (s-BPDA) as an acid component was added portionwise with stirring at 40 °C to a substantially equimolar amount to PPD to initiate a reaction, giving a polyamic-acid polymerization solution (polyimide precursor solution) with a solid concentration of 18 % by mass. Then, to this polyamic-acid polymerization solution, monostearyl phosphoric ester triethanolamine salt was added in a proportion of 0.25 parts by mass based on 100 parts by mass of the polyamic acid and the mixture was homogeneously mixed to give a polyamic acid solution I-A. A rotational viscosity of the polyamic acid solution I-A at 30 °C was 180 Pa ·s.

<u>Preparation of a polyamic-acid solution composition I-A</u>

To the polyamic acid solution I-A was further added 1,2-dimethylimidazole as an imidization catalyst in 0.05 equivalent to the amic acid unit, to give a polyamic acid solution composition I-A.

Preparation of a polyamic acid solution I-B and a coating solution I-1

In a polymerization vessel were charged N,N-dimethylacetamide (DMAc) and 2,4-bis(4-aminoanilino)-6-anilino-1,3,5-triazine(ATDA) as a diamine component in predetermined amounts. Then, to the mixture, 3,3',4,4'-biphenyltetracarboxylic dianhydride (s-BPDA) was added portionwise with stirring at 40 °C to a substantially equimolar amount to the total diamine components to initiate a reaction, giving a polyamic-acid polymerization solution I-B (polyimide precursor solution) with a solid concentration of 18 % by mass.

To the polyamic acid solution I-B was added DMAc to give a polyamic-acid solution (polyimide precursor solution) with a solid concentration of 5 % by mass as a coating solution I-1.

Preparation of a polyamic acid solution I-C and a coating solution 1-2

In a polymerization vessel were charged N,N-dimethylacetamide (DMAc), paraphenylene diamine (PPD) and 2,4-bis(4-aminoanilino)-6-anilino-1,3,5-triazine(ATDA) in predetermined amounts. The amount of ATDA was 70 mol% based on the total diamine components. Then, to the mixture, 3,3',4,4'-biphenyltetracarboxylic dianhydride (s-BPDA) was added portionwise with stirring at 40 °C to a substantially equimolar amount to the total diamine components to initiate a reaction, giving a polyamic-acid polymerization solution I-C (polyimide precursor solution) with a solid concentration of 18 % by mass.

To the polyamic acid solution I-C, DMAc was added to give a polyamic-acid solution (polyimide precursor solution) with a solid concentration of 5 % by mass as a coating solution I-2.

Preparation of a polyamic acid solution I-D and a coating solution I-3

A polyamic-acid polymerization solution I-D (polyimide precursor solution) was prepared as described for the preparation of the polyamic acid solution I-C except that the amount of ATDA was 50 mol% based on the total diamine components. Then, DMAc was added to the polyamic acid solution I-D, to give a polyamic acid solution (polyimide precursor solution) with a solid concentration of 5 % by mass as a coating solution I-3.

Preparation of a polyamic acid solution I-E and a coating solution I-4

A polyamic-acid polymerization solution I-E (polyimide precursor solution) was prepared as described for the preparation of the polyamic acid solution I-C except that the amount of ATDA was 30 mol% based on the total diamine components. Then, DMAc was added to the polyamic acid solution I-E, to give a polyamic acid solution (polyimide precursor solution) with a solid concentration of 5 % by mass as a coating solution I-4.

Preparation of a polyamic acid solution I-F and a coating solution I-5

A polyamic-acid polymerization solution I-F (polyimide precursor solution) was prepared as described for the preparation of the polyamic acid solution I-C except that the amount of ATDA was 19 mol% based on the total diamine components. Then, DMAc was added to the polyamic acid solution I-F, to give a polyamic acid solution (polyimide precursor solution) with a solid concentration of 5 % by mass as a coating solution I-5.

Preparation of a polyamic acid solution I-G and a coating solution I-6

In a polymerization vessel were charged N,N-dimethylacetamide (DMAc) and 2,4-bis(4-aminoanilino)-6-anilino-1,3,5-triazine(ATDA) in predetermined amounts. Then, to the mixture, pyromellitic dianhydride (PMDA) as an acid component was added portionwise with stirring at 40 °C to a substantially equimolar amount to the total diamine components to initiate a reaction, giving a polyamic-acid polymerization solution I-G (polyimide precursor solution) with a solid concentration of 18 % by mass. To the polyamic acid solution I-G, DMAc was added to give a polyamic-acid solution (polyimide precursor solution) with a solid concentration of 5 % by mass as a coating solution I-6.

Preparation of a polyamic acid solution I-H and a coating solution I-7

In a polymerization vessel were charged N,N-dimethylacetamide (DMAc), paraphenylene diamine (PPD) and 2,4-bis(4-aminoanilino)-6-anilino-1,3,5-triazine(ATDA) in predetermined amounts. The amount of ATDA was 80 mol% and that of PPD was 20 mol% based on the total diamine components. Then, to the mixture, pyromellitic dianhydride (PMDA) was added portionwise with stirring at 40 °C to a substantially equimolar amount to the total diamine components to initiate a reaction, giving a polyamic-acid polymerization solution I-H (polyimide precursor solution) with a solid concentration of 18 % by mass. To the polyamic acid solution I-H, DMAc was added to give a polyamic-acid solution (polyimide precursor solution) with a solid concentration of 5 % by mass as a coating solution I-7.

Preparation of a polyamic acid solution I-I and a coating solution I-8

In a polymerization vessel were charged N,N-dimethylacetamide (DMAc), 4,4'-diaminodiphenyl ether (DADE) and 2,4-bis(4-aminoanilino)-6-anilino-1,3,5-triazine(ATDA) in predetermined amounts. The amount of ATDA was 80 mol% and that of DADE was 20 mol% based on the total diamine components. Then, to the mixture, 3,3',4,4'-biphenyltetracarboxylic dianhydride (s-BPDA) and pyromellitic dianhydride (PMDA) were added portionwise with stirring at 40 °C to a substantially equimolar amount to the total diamine components to initiate a reaction, giving a polyamic-acid polymerization solution I-I (polyimide precursor solution) with a solid concentration of 18 % by mass. The amount of s-BPDA was 80 mol% and that of PMDA was 20 mol% based on the total acid dianhydride component. To the polyamic acid solution I-I, DMAc was added to give a polyamic-acid solution (polyimide precursor solution) with a solid concentration of 5 % by mass as a coating solution I-8.

Reference Experiment: 5 % weight loss temperature

(i) A self-supporting film formed from the polyamic acid solution I-B was heated under such condition that the temperature is raised from 150 °C to 370 °C over about 11 min, to produce a polyimide film with a thickness of 35 μm, for which a 5 % weight loss temperature was determined in the air by TGA.
Measurement result: the polyimide produced from the polyamic acid solution T-B: 455 °C.
(ii) A self-supporting film formed from the polyamic acid solution I-F was heated under such condition that the temperature is raised from 150 °C to 490 °C over about 18 min, to produce a polyimide film with a thickness of 35 μm, for which a 5 % weight loss temperature was determined in the air by TGA.
Measurement result: the polyimide produced from the polyamic acid solution I-F: 562 °C
From the above description, it is shown that the polyimide from the polyamic acid solution I-F had a higher 5 % weight loss temperature.

Example A1

A polyamic-acid solution composition I-A was cast as a thin film on a glass plate, and heated by a hot plate at 138 °C for 60 sec. The film was peeled from the glass plate to give a self-supporting film with a weight-loss-after-heating of 36.8 % by mass.
On side A of the self-supporting film, the coating solution I-1 was applied using a bar coater No.3 (application amount: 6 g/$m^2$), and the product was fixed at four sides with pin tenters and heated stepwise for imidization in an oven, that is, at 150 °C for 50 sec., at 210 °C for 50 sec., at 370 °C for 50 sec. to give a polyimide film (PI-A1).
A polyimide laminate A (PI-A1) in which a coverlay was laminated on side A (application side) was produced using the polyimide film (PI-A1) as described in the section "Evaluation method". A peeling strength of the polyimide laminate A (PI-A1) was determined and the result is shown in Table A1.
Although being not described in the following examples, heating was conducted, as described above, in an oven while a self-supporting film was fixed at four sides with pintenters unless otherwise indicated. Furthermore, in the following examples, a peeling strength was also determined using a polyimide laminate A produced by laminating a coverlay on a surface to be evaluated (a surface on which a coating solution was applied) by the method described in the section "Evaluation method", unless otherwise indicated. The results of examples are shown in Table A (Tables A1 and A2). A polyimide laminate A produced by laminating a coverlay is called, for example, a polyimide laminate A (PI-A1) using the same name (for example, PI-A1) of a polyimide film.
Table A (Tables A1 and A2) shows a weight-loss-after-heating, a coating solution and a coating surface (a surface of a polyimide film on which an adhesive layer is formed) of a self-supporting film; an average thickness of a polyimide film obtained, the other conditions and the results.

Example A2

A polyimide film (PI-A2) was produced as described in Example A1, except that side B of a self-supporting film formed as described for Example A1 was selected.

Example A3

To side A of a self-supporting film formed as described in Example A1 was applied the coating solution 1-1 by

a bar coater No.3 (application amount: 6 g/m$^2$), which was then subjected to imidization by heating stepwise at 150 °C for 50 sec., at 210 °C for 50 sec., at 370 °C for 50 sec., at 490 °C for 50 sec., to give a polyimide film (PI-A3).

Example A4

A polyimide film (PI-A4) was produced as described in Example A3, except that side B was a surface to which a coating solution was applied.

Example A5

To side A of a self-supporting film formed as described in Example A1 was applied the coating solution 1-2 by a bar coater No.3 (application amount: 6 g/m$^2$), which was then subjected to imidization by continuously heating at a temperature from 150 °C to 370 °C over about 11 min, to give a polyimide film (PI-A5).

Example A6

A polyimide film (PI-A6) was produced as described in Example A5, except that side B was a surface to which a coating solution was applied.

Example A7

To side A of a self-supporting film formed as described in Example A1 was applied the coating solution I-2 by a bar coater No.3 (application amount: 6 g/m$^2$), which was then subjected to imidization by continuously heating at a temperature from 150 °C to 490 °C over about 18 min, to give a polyimide film (PI-A7).

Example A8

A polyimide film (PI-A8) was produced as described in Example A7, except that side B was a surface to which a coating solution was applied.

Example A9

To side A of a self-supporting film formed as described in Example A1 was applied the coating solution I-3 by a bar coater No.3 (application amount: 6 g/m$^2$), which was then subjected to imidization by continuously heating at a temperature from 150 °C to 370 °C over about 11 min, to give a polyimide film (PI-A9).

Example A10

A polyimide film (PI-A10) was produced as described in Example A9, except that side B was a surface to which a coating solution was applied.

Example All

To side A of a self-supporting film formed as described in Example A1 was applied the coating solution I-3 by a bar coater No.3 (application amount: 6 g/m$^2$), which was then subjected to imidization by continuously heating at a temperature from 150 °C to 490 °C over about 18 min, to give a polyimide film (PI-A11).

Example A12

A polyimide film (PI-A12) was produced as described in Example A11, except that side B was a surface to which a coating solution was applied.

Example A13

To side A of a self-supporting film formed as described in Example A1 was applied the coating solution I-4 by a bar coater No.3 (application amount: 6 g/m$^2$), which was then subjected to imidization by continuously heating at a temperature from 150 °C to 370 °C over about 11 min, to give a polyimide film (PI-A13).

Example A14

A polyimide film (PI-A14) was produced as described in Example A13, except that side B was a surface to which a coating solution was applied.

Example A15

To side A of a self-supporting film formed as described in Example A1 was applied the coating solution I-4 by a bar coater No.3 (application amount: 6 g/$m^2$), which was then subjected to imidization by continuously heating at a temperature from 150 °C to 490 °C over about 18 min, to give a polyimide film (PI-A15).

Example A16

A polyimide film (PI-A16) was produced as described in Example A15, except that side B was a surface to which a coating solution was applied.

Example A17

On a glass plate was cast a polyamic-acid solution I-A (free from 1,2-dimethylimidazole) as a thin film, which was then heated at 138 °C using a hot plate and then peeled from the glass plate, to give a self-supporting film. To side A of the self-supporting film was applied the coating solution I-4 by a bar coater No.3 (application amount: 6 g/$m^2$), which was then subjected to imidization by continuously heating at a temperature from 150 °C to 370 °C over about 11 min, to give a polyimide film (PI-A17).

Example A18

A polyimide film (PI-A18) was produced as described in Example A17, except that side B was a surface to which a coating solution was applied.

Example A19

To side A of a self-supporting film formed as described in Example A17 was applied the coating solution I-4 by a bar coater No.3 (application amount: 6 g/$m^2$), which was then subjected to imidization by continuously heating at a temperature from 150 °C to 490 °C over about 18 min, to give a polyimide film (PI-A19).

Example A20

A polyimide film (PI-A20) was produced as described in Example A19, except that side B was a surface to which a coating solution was applied.

Example A21

To side A of a self-supporting film formed as described in Example A1 was applied the coating solution I-5 by a bar coater No.3 (application amount: 6 g/$m^2$), which was then subjected to imidization by continuously heating at a temperature from 150 °C to 370 °C over about 11 min, to give a polyimide film (PI-A21).

Example A22

A polyimide film (PI-A22) was produced as described in Example A21, except that side B was a surface to which a coating solution was applied.

Example A23

To side A of a self-supporting film formed as described in Example A1 was applied the coating solution I-5 by a bar coater No.3 (application amount: 6 g/$m^2$), which was then subjected to imidization by continuously heating at a temperature from 150 °C to 490 °C over about 18 min, to give a polyimide film (PI-A23).

Example A24

A polyimide film (PI-A24) was produced as described in Example A23, except that side B was a surface to which a coating solution was applied.

Example A25

To side A of a self-supporting film formed as described in Example A17 was applied the coating solution I-5 by a bar coater No.3 (application amount: 6 g/$m^2$), which was then subjected to imidization by continuously heating at a temperature from 150 °C to 370 °C over about 11 min, to give a polyimide film (PI-A25).

Example A26

A polyimide film (PI-A26) was produced as described in Example A25, except that side B was a surface to which a coating solution was applied.

Example A27

On side A of a self-supporting film formed as described in Example A17 was applied the coating solution I-5 using a bar coater No.3 (application amount: 6 g/$m^2$), and the product was fixed at four sides with pin tenters and subjected to imidization by continuously heating in an oven at a temperature from 150 °C to 490 °C over about 18 min, to give a polyimide film (PI-A27).

Example A28

A polyimide film (PI-A28) was produced as described in Example A27, except that side B was a surface to which a coating solution was applied.

Example A29

On side A of a self-supporting film formed as described in Example A1 was applied the coating solution I-6 by a bar coater No.3 (application amount: 6 g/$m^2$), which was then subjected to imidization by continuously heating at a temperature from 150 °C to 370 °C over about 11 min, to give a polyimide film (PI-A29).

Example A30

A polyimide film (PI-A30) was produced as described in Example A29, except that side B was a surface to which a coating solution was applied.

Example A31

On side A of a self-supporting film formed as described in Example A1 was applied the coating solution I-6 using a bar coater No.3 (application amount: 6 g/$m^2$), and the product was fixed at four sides with pin tenters and subjected to imidization by continuously heating in an oven at a temperature from 150 °C to 490 °C over about 18 min, to give a polyimide film (PI-A31).

Example A32

A polyimide film (PI-A32) was produced as described in Example A31, except that side B was a surface to which a coating solution was applied.

Example A33

To side A of a self-supporting film formed as described in Example A1 was applied the coating solution I-7 by a bar coater No.3 (application amount: 6 g/$m^2$), which was then subjected to imidization by continuously heating at a temperature from 150 °C to 370 °C over about 11 min, to give a polyimide film (PI-A33).

Example A34

A polyimide film (PI-A34) was produced as described in Example A33, except that side B was a surface to which a coating solution was applied.

Example A35

To side A of a self-supporting film formed as described in Example A1 was applied the coating solution I-7 by a bar coater No.3 (application amount: 6 $g/m^2$), which was then subjected to imidization by continuously heating at a temperature from 150 °C to 490 °C over about 18 min, to give a polyimide film (PI-A35).

Example A36

A polyimide film (PI-A36) was produced as described in Example A35, except that side B was a surface to which a coating solution was applied.

Example A37

To side A of a self-supporting film formed as described in Example A1 was applied the coating solution I-8 by a bar coater No.3 (application amount: 6 $g/m^2$), which was then subjected to imidization by continuously heating at a temperature from 150 °C to 370 °C over about 11 min, to give a polyimide film (PI-A37).

Example A38

A polyimide film (PI-A38) was produced as described in Example A37, except that side B was a surface to which a coating solution was applied.

Example A39

To side A of a self-supporting film formed as described in Example A1 was applied the coating solution I-8 by a bar coater No.3 (application amount: 6 $g/m^2$), which was then subjected to imidization by continuously heating at a temperature from 150 °C to 490 °C over about 18 min, to give a polyimide film (PI-A39).

Example A40

A polyimide film (PI-A40) was produced as described in Example A39, except that side B was a surface to which a coating solution was applied.

Comparative Example A1

A self-supporting film with a weight-loss-after-heating of 35.6 % by mass was produced as described in Example A27. The self-supporting film, without coating a polymer solution, was fixed at four sides by pintenters and subjected to imidization by continuously heating in an oven at a temperature from 150 °C to 490 °C over about 18 min, to give a polyimide film (PI-A41). A peeling strength was determined for a polyimide laminate A(PI-A41) produced by laminating a coverlay on side A.

Comparative Example A2

A self-supporting film with a weight-loss-after-heating of 35.6 % by mass was produced as described in Example A27. The self-supporting film, without coating a polymer solution, was fixed at four sides by pintenters and subjected to imidization by continuously heating in an oven at a temperature from 150 °C to 490 °C over about 18 min, to give a polyimide film (PI-A42). A peeling strength was determined for a polyimide laminate A(PI-A42) produced by laminating a coverlay on side B.

Table A1

| | Acid component | | Diamine component | | | Weight-loss-after-heating in self-supporting film | Solution for coating | Coated surface of film | Maximum heating temperature | Polyimide film | | Peeling strength of polyimide laminate A | | Peeling mode | |
|---|---|---|---|---|---|---|---|---|---|---|---|---|---|---|---|
| | s-BPDA | PMDA | PPD | DADE | ATDA | | | | | Type | Thickness | Initial A | Post-heating A | Initial A | Post-heating A |
| | mol% | | | | | wt% | | | °C | | µm | kN/m | kN/m | | |
| Example A1 | 100 | 0 | 0 | 0 | 100 | 36.8 | I-1 | Side A | 370 | PI-A1 | 16 | - | 0.59 | - | 2 |
| Example A2 | 100 | 0 | 0 | 0 | 100 | 34.6 | I-1 | Side B | 370 | PI-A2 | 14 | 0.91 | 0.61 | 2 | 2 |
| Example A3 | 100 | 0 | 0 | 0 | 100 | 36.0 | I-1 | Side A | 490 | PI-A3 | 15.5 | 0.57 | 0.61 | 3 | 2 |
| Example A4 | 100 | 0 | 0 | 0 | 100 | 37.3 | I-1 | Side B | 490 | PI-A4 | 16.5 | 0.61 | 0.63 | 3 | 2 |
| Example A5 | 100 | 0 | 30 | 0 | 70 | 35.2 | I-2 | Side A | 370 | PI.A5 | 13.5 | 0.60 | 0.47 | 4 | 4 |
| Example A6 | 100 | 0 | 30 | 0 | 70 | 34.9 | I-2 | Side B | 370 | PI-A6 | 13 | 0.59 | 0.92 | 4 | 2 |
| Example A7 | 100 | 0 | 30 | 0 | 70 | 35.7 | I-2 | Side A | 490 | PI-A7 | 13 | 0.20 | 0.47 | 3 | 4 |
| Example A8 | 100 | 0 | 30 | 0 | 70 | 36.7 | I-2 | Side B | 490 | PI-A8 | 14 | 0.20 | 0.61 | 3 | 4 |
| Example A9 | 100 | 0 | 50 | 0 | 60 | 34.6 | I-3 | Side A | 370 | PI-A9 | 13 | 0.60 | 0.33 | 4 | 3 |
| Example A10 | 100 | 0 | 50 | 0 | 50 | 37.3 | I-3 | Side B | 370 | PI-A10 | 14 | 0.62 | 0.28 | 4 | 3 |
| Example A11 | 100 | 0 | 50 | 0 | 50 | 35.7 | I-3 | Side A | 490 | PI-A11 | 12 | 0.27 | 0.84 | 3 | 4 |
| Example A12 | 100 | 0 | 50 | 0 | 50 | 35.4 | I-3 | Side B | 490 | PI-A12 | 13.5 | 0.21 | 0.49 | 3 | 4 |
| Example A13 | 100 | 0 | 70 | 0 | 30 | 37.7 | I-4 | Side A | 370 | PI-A13 | 14 | 0.52 | 0.25 | 3 | 3 |
| Example A14 | 100 | 0 | 70 | 0 | 30 | 37.3 | I-4 | Side B | 370 | PI-A14 | 13 | 0.50 | 0.19 | 3 | 3 |
| Example A15 | 100 | 0 | 70 | 0 | 30 | 38.3 | I-4 | Side A | 490 | PI-A15 | 13 | 0.23 | 0.45 | 3 | 3 |

(continued)

| | mol% | | | | | wt% | | | °C | | μm | kN/m | kN/m | | |
|---|---|---|---|---|---|---|---|---|---|---|---|---|---|---|---|
| Example A16 | ion | 0 | 70 | 0 | 30 | 34.9 | I-4 | Side B | 490 | PI-A16 | 12 | 0.33 | 0.33 | 3 | 3 |
| Example A17 | 100 | 0 | 70 | 0 | 30 | 36.8 | I-4 | Side A | 370 | PI-A17 | 12.5 | 0.68 | 0.18 | 1 | 3 |
| Example A18 | 100 | 0 | 70 | 0 | 30 | 37.3 | I-4 | Side B | 370 | PI-A18 | 12 | 0.65 | 0.18 | 1 | 3 |
| Example A19 | 100 | 0 | 70 | 0 | 30 | 35.7 | I-4 | Side A | 490 | PI-A19 | 13 | 1.00 | 0.53 | 1 | 3 |
| Example A20 | 100 | 0 | 70 | 0 | 30 | 35.4 | I-4 | Side B | 490 | PI-A20 | 11 | 0.44 | 0.34 | 4 | 3 |
| Example A21 | 100 | 0 | 81 | 0 | 19 | 35.4 | I-5 | Side A | 370 | PI-A21 | 13 | 0.43 | 0.28 | 3 | 3 |
| Example A22 | 100 | 0 | 81 | 0 | 19 | 35.0 | I-5 | Side B | 370 | PI-A22 | 11 | 0.47 | 0.18 | 3 | 3 |
| Example A23 | 100 | 0 | 81 | 0 | 19 | 34.0 | I-5 | Side A | 490 | PI-A23 | 11.5 | 0.31 | 0.32 | 3 | 3 |
| Example A24 | 100 | 0 | 81 | 0 | 19 | 38.4 | I-5 | Side B | 490 | PI-A24 | 12.5 | 0.39 | 0.31 | 3 | 3 |
| Example A25 | 100 | 0 | 81 | 0 | 19 | 34.5 | I-5 | Side A | 370 | PI-A25 | 13 | 0.87 | 0.13 | 2 | 3 |
| Example A26 | 100 | 0 | 81 | 0 | 19 | 36.4 | I-5 | Side B | 370 | PI-A26 | 13 | 0.95 | 0.13 | 2 | 3 |
| Example A27 | 100 | 0 | 81 | 0 | 19 | 35.6 | I-5 | Side A | 490 | PI.A27 | 13 | 0.81 | 0.21 | 2 | 3 |
| Example A28 | 100 | 0 | 81 | 0 | 19 | 35.2 | I-5 | Side B | 490 | PI-A28 | 12 | 0.82 | 0.25 | 2 | 3 |
| Comparative Example A1 | - | - | - | - | - | 35.6 | - | Side A | 490 | PI-A41 | 12.5 | 0.25 | 0.10 | 3 | 3 |
| Comparative Example A2 | - | - | - | - | - | 35.6 | - | Side B | 490 | PI-A42 | 12.5 | 0.32 | 0.16 | 4 | 3 |

(continued)

| | mol% | | | | | wt% | | | °C | | µm | kN/m | kN/m | | |
|---|---|---|---|---|---|---|---|---|---|---|---|---|---|---|---|
| Comparative Example A3 | - | - | - | - | - | - | - | Side A | 370 | PI-A43 | 13 | 0.27 | 0.07 | 3 | 3 |
| Comparative Example A4 | - | - | - | - | - | - | - | Side B | 370 | PI-A44 | 12.5 | 0.38 | 0.12 | 4 | 3 |

Table A2

| | Acid component | | Diamine component | | | Weight-loss-after-heating in a self-supporting film | Solution for coating | Coated surface of film | Maximum heating temperature (°C) | Polyimide film | | Peeling strength of polymide metal laminate A | | Peeling mode | |
|---|---|---|---|---|---|---|---|---|---|---|---|---|---|---|---|
| | s-BPDA | PMDA | PPD | DADE | ATDA | | | | | Type | Thickness | Initial A | Post-heatmg A | Initial A | Post-heating A |
| | mol% | | | | | wt% | | | °C | | μm | kN/m | kN/m | | |
| Example A29 | 0 | 100 | 0 | 0 | 100 | 34 | I-6 | Side A | 370 | PI-A29 | 12.5 | 0.17 | 0.87 | 3 | 2 |
| Example A30 | 0 | 100 | 0 | 0 | 100 | 34.8 | I-6 | Side B | 370 | PI-A30 | 14.5 | 025 | 0.99 | 3 | 2 |
| Example A31 | 0 | 100 | 0 | 0 | 100 | 35.2 | I-6 | Side A | 490 | PI-A31 | 15.5 | 0.19 | 0.74 | 3 | 2 |
| Example A32 | 0 | 100 | 0 | 0 | 100 | 34.9 | I-6 | Side B | 490 | PI-A32 | 14 | 0.19 | 0.81 | 3 | 2 |
| Example A33 | 0 | m | 20 | 0 | 80 | 36.3 | I-7 | Side A | 370 | PI-A33 | 16 | 0.18 | 0.67 | 3 | 2 |
| Example A34 | 0 | 100 | 20 | 0 | 80 | 33.7 | I-7 | Side B | 370 | PI-A34 | 13.5 | 0.22 | 1.08 | 3 | 2 |
| Example A35 | 0 | 100 | 20 | 0 | 80 | 33.2 | I-7 | Side A | 490 | PI-A35 | 13 | 0.14 | 0.51 | 3 | 2 |
| Example A36 | 0 | 100 | 20 | 0 | 80 | 35.5 | I-7 | Side B | 490 | PI-A36 | 13.5 | 0.18 | 0.77 | 3 | 2 |
| Example A37 | 80 | 20 | 0 | 20 | 80 | 34.6 | I-8 | Side A | 370 | PI-A37 | 15 | 0.28 | 0.72 | 3 | 2 |
| Example A38 | 80 | 20 | 0 | 20 | 80 | 35 | I-8 | Side B | 370 | PI-A38 | 13.5 | 0.26 | 0.79 | 3 | 2 |

(continued)

| | Acid component | | Diamine component | | | Weight-loss-after-heating in a self-supporting film | Solution for coating | Coated surface of film | Maximum heating temperature (°C) | Polyimide film | | Peeling strength of polymide metal laminate A | | Peeling mode | |
|---|---|---|---|---|---|---|---|---|---|---|---|---|---|---|---|
| | s-BPDA | PMDA | PPD | DADE | ATDA | | | | | Type | Thickness | Initial A | Post-heatmg A | Initial A | Post-heating A |
| | mol% | | | | | wt% | | | °C | | µm | kN/m | kN/m | | |
| Example A39 | 80 | 20 | 0 | 20 | 80 | 36.8 | I-8 | Side A | 490 | PI-A39 | 15.5 | 0.24 | 0.45 | 3 | 4 |
| Example A40 | 80 | 20 | 0 | 20 | 80 | 34 | I-8 | Side B | 490 | PI-A40 | 13 | 0.21 | 0.58 | 3 | 4 |
| Comparative Example A1 | - | - | - | - | - | 35.6 | - | Side A | 490 | PI-A41 | 12.5 | 0.25 | 0.10 | 3 | 3 |
| Comparative Example A2 | - | - | - | - | - | 35.6 | - | Side B | 490 | PI-A42 | 125 | 0.32 | 0.16 | 4 | 3 |
| Comparative Example A3 | - | - | - | - | - | | - | Side A | 370 | PI-A43 | 13 | 0.27 | 0.07 | 3 | 3 |
| Comparative Example A4 | - | - | - | - | - | | - | Side B | 370 | PI-A44 | 12.5 | 0.38 | 0.12 | 4 | 3 |

For these examples, the followings are found.

1) In Examples A2 to A4 and A25 to A28, all of polyimide laminates A exhibit excellent initial peeling strength.
2) Examples A1 to A4 exhibited more excellent post-heating peeling strength in comparison with Examples A25 to A28. This is presumably due to influence of a content of the diamine represented by general formula (1).
3) Examples A3 and A4 exhibited more excellent post-heating peeling strength in comparison with Examples A1 and A2. This is presumably due to influence of a maximum heating temperature of the film.
4) In terms of post-heating peeling strength of sides A and B of the film, side B tends to be relatively higher in Examples A1 to A4.

Furthermore, the followings are main findings for these examples.

5) In the case where ATDA is used, a post-heating peeling strength of the polyimide laminate A is higher than the case where ATFA is not used.
6) A ratio of post-heating peeling strength to initial peeling strength (post-heating peeling strength/initial peeling strength) is particularly as large as 0.45 to 3.1 when the amount of ATDA in a diamine component is 50 to 70 mol%.
7) In the case of curing at 490 °C, post-heating peeling strength tends to be higher than the case of curing at 370 °C for each example when a solution is applied on the same surface.
8) In Examples A29 to A40 (where a tetracarboxylic acid component is PMDA), a ratio of post-heating peeling strength/initial peeling strength is as very large as about 1.9 to 5.1 and peeling strength is significantly increased after heating. Furthermore, peeling mode is cohesion failure of an adhesive, so that adhesiveness could be higher than the indicated numerical value.

<<Example Part II (Examples corresponding to Part 2)>>

<u>Preparation of a polyamic acid solution II-A</u>

In a polymerization vessel were charged N,N-dimethylacetamide (DMAc) and 2,4-bis(4-aminoanilino)-6-anilino-1,3,5-triazine(ATDA) in predetermined amounts. Then, to the mixture, 3,3',4,4'-biphenyltetracarboxylic dianhydride (s-BPDA) was added portionwise with stirring at 40 °C to a substantially equimolar amount to the total diamine components to initiate a reaction, giving a polyamic-acid polymerization solution II-A (polyimide precursor solution) with a solid concentration of 18 % by mass. Then, to this polyamic-acid polymerization solution II-A, monostearyl phosphoric ester triethanolamine salt was added in a proportion of 0.25 parts by mass based on 100 parts by mass of the polyamic acid and the mixture was homogeneously mixed to give a polyamic acid solution II-A. A rotational viscosity of the polyamic acid solution II-A at 30 °C was 170 Pa s.

<u>Preparation of a polyamic acid solution II-B</u>

In a polymerization vessel were charged N,N-dimethylacetamide (DMAc), paraphenylene diamine (PPD) and 2,4-bis(4-aminoanilino)-6-anilino-1,3,5-triazine(ATDA) in predetermined amounts. The amount of ATDA was 30 mol% based on the total diamine components. Then, to the mixture, 3,3',4,4'-biphenyltetracarboxylic dianhydride (s-BPDA) was added portionwise with stirring at 40 °C to a substantially equimolar amount to the total diamine components to initiate a reaction, giving a polyamic-acid polymerization solution II-B (polyimide precursor solution) with a solid concentration of 18 % by mass. Then, to this polyamic-acid polymerization solution II-B, monostearyl phosphoric ester triethanolamine salt was added in a proportion of 0.25 parts by mass based on 100 parts by mass of the polyamic acid and the mixture was homogeneously mixed to give a polyamic acid solution II-B. A rotational viscosity of the polyamic acid solution II-B at 30 °C was 150 Pa·s.

<u>Preparation of a polyamic acid solution II-C</u>

A polyamic acid solution II-C was prepared as described for the preparation of a polyamic acid solution II-B except that the amount of ATDA is 19 mol% based on the total diamine components. The polyamic acid solution II-C had a rotational viscosity of 170 Pa·s at 30 °C.

<u>Preparation of a polyamic acid solution II-D</u>

A polyamic acid solution II-D was prepared as described for the preparation of a polyamic acid solution II-B except that the amount of ATDA is 10 mol% based on the total diamine components. The polyamic acid solution II-D

had a rotational viscosity of 110 Pa·s at 30 °C.

Preparation of a polyamic acid solution II-E

A polyamic acid solution II-E was prepared as described for the preparation of a polyamic acid solution II-B except that the amount of ATDA is 6.2 mol% based on the total diamine components. The polyamic acid solution II-E had a rotational viscosity of 150 Pa·s at 30 °C.

Preparation of a polyamic acid solution II-F

In a polymerization vessel were charged N,N-dimethylacetamide (DMAc) and 2,4-bis(4-aminoanilino)-6-anilino-1,3,5-triazine(ATDA) in predetermined amounts. Then, to the mixture, pyromellitic dianhydride (PMDA) was added portionwise with stirring at 40 °C to a substantially equimolar amount to the total diamine components to initiate a reaction, giving a polyamic-acid polymerization solution II-F (polyimide precursor solution) with a solid concentration of 18 % by mass. Then, to this polyamic-acid polymerization solution II-F, monostearyl phosphoric ester triethanolamine salt was added in a proportion of 0.25 parts by mass based on 100 parts by mass of the polyamic acid and the mixture was homogeneously mixed to give a polyamic acid solution II-F. A rotational viscosity of the polyamic acid solution II-F at 30 °C was 190 Pa·s.

Preparation of a polyamic acid solution II-G

In a polymerization vessel were charged N,N-dimethylacetamide (DMAc), paraphenylene diamine (PPD) and 2,4-bis(4-aminoanilino)-6-anilino-1,3,5-triazine(ATDA) in predetermined amounts. The amount of ATDA was 80 mol% based on the total diamine components. Then, to the mixture, pyromellitic dianhydride (PMDA) was added portionwise with stirring at 40 °C to a substantially equimolar amount to the total diamine components to initiate a reaction, giving a polyamic-acid polymerization solution II-G (polyimide precursor solution) with a solid concentration of 18 % by mass. Then, to this polyamic-acid polymerization solution II-G, monostearyl phosphoric ester triethanolamine salt was added in a proportion of 0.25 parts by mass based on 100 parts by mass of the polyamic acid and the mixture was homogeneously mixed to give a polyamic acid solution II-G. A rotational viscosity of the polyamic acid solution II-G at 30 °C was 90 Pa ·s.

Preparation of a polyamic acid solution II-H

In a polymerization vessel were charged N,N-dimethylacetamide (DMAc), 4,4'-diaminodiphenyl ether (DADE), paraphenylene diamine (PPD) and 2,4-bis(4-aminoanilino)-6-anilino-1,3,5-triazine(ATDA) in predetermined amounts. The amount of ATDA was 80 mol% based on the total diamine components. Then, to the mixture, 3,3',4,4'-biphenyltetracarboxylic dianhydride (s-BPDA) and pyromellitic dianhydride (PMDA) were added portionwise with stirring at 40 °C to a substantially equimolar amount to the total diamine components to initiate a reaction, giving a polyamic-acid polymerization solution II-H (polyimide precursor solution) with a solid concentration of 18 % by mass. The content of s-BPDA in the total acid dianhydride components was 80 mol%. Then, to this polyamic-acid polymerization solution II-H, monostearyl phosphoric ester triethanolamine salt was added in a proportion of 0.25 parts by mass based on 100 parts by mass of the polyamic acid and the mixture was homogeneously mixed to give a polyamic acid solution II-H. A rotational viscosity of the polyamic acid solution II-H at 30 °C was 120 Pa ·s.

Example B1

A polyamic acid solution II-A was cast as a thin film on a glass plate, and heated by a hot plate at 138 °C for 60 sec. The film was peeled from the glass plate to give a self-supporting film with a weight-loss-after-heating of 33.6 % by mass.

This self-supporting film with side A up was fixed at four sides by pintenters and subjected to imidization by continuously heating in an oven at a temperature from 150 °C to 370 °C over about 11 min, to give a polyimide film (PI-B1). A polyimide laminate A (PI-B1) in which a coverlay was laminated on side A was produced using the polyimide film (PI-B1) as described in the section "Evaluation method". A peeling strength of the polyimide laminate A (PI-B1) was determined and the result is shown in Table B.

Although being not described in the following examples, heating was conducted, as described above, in an oven while a self-supporting film was fixed at four sides with pintenters unless otherwise indicated. Furthermore, in the following examples, a peeling strength was also determined using a polyimide laminate A produced by laminating a coverlay on a surface to be evaluated by the method described in the section "Evaluation method", unless otherwise indicated. The results of examples are shown in Table B. A polyimide laminate A produced by laminating a coverlay is

called, for example, a polyimide laminate A (PI-B1) using the same name (for example, PI-B1) of a polyimide film.

Table B shows a weight-loss-after-heating of a self-supporting film, an average thickness of a polyimide film obtained, a surface of a polyimide film on which an adhesive layer is formed, the other conditions and the results.

Example B2

A polyimide film (PI-B2) was produced as described in Example B1 except that a self-supporting film produced as described in Example B1 was used with side B up.

Example B3

A self-supporting film produced as described in Example B1 with side A up was subjected to imidization by continuously heating at a temperature from 150 °C to 490 °C over about 18 min, to give a polyimide film (PI-B3).

Example B4

A polyimide film (PI-B4) was produced as described in Example B3 except that a self-supporting film produced as described in Example B1 was used with side B up.

Example B5

The polyamic acid solution II-B was cast as a film on a glass plate, heated at 138 °C for 60 sec. using a hot plate, and then peeled from the glass plate to give a self-supporting film. This self-supporting film with side A up was subjected to imidization by continuously heating at a temperature from 150 °C to 370 °C over about 11 min, to give a polyimide film (PI-B5).

Example B7

A self-supporting film produced as described in Example B5 with side A up was subjected to imidization by continuously heating at a temperature from 150 °C to 490 °C over about 18 min, to give a polyimide film (PI-B7).

Example B8

A polyimide film (PI-B8) was produced as described in Example B7 except that a self-supporting film produced as described in Example B5 was used with side B up.

Example B9

The polyamic acid solution II-C was cast as a film on a glass plate, heated at 138 °C for 210 sec. using a hot plate, and then peeled from the glass plate to give a self-supporting film. This self-supporting film with side A up was subjected to imidization by continuously heating at a temperature from 150 °C to 370 °C over about 11 min, to give a polyimide film (PI-B9).

Example B10

A polyimide film (PI-B10) was produced as described in Example B9 except that a self-supporting film produced as described in Example B9 was used with side B up.

Example B11

A self-supporting film produced as described in Example B9 with side A up was subjected to imidization by continuously heating at a temperature from 150 °C to 490 °C over about 18 min, to give a polyimide film (PI-B11).

Example B12

A polyimide film (PI-B12) was produced as described in Example B11 except that a self-supporting film produced as described in Example B9 was used with side B up.

Example B13

The polyamic acid solution II-C was cast as a film on a glass plate, heated at 138 °C for 60 sec. using a hot plate, and then peeled from the glass plate to give a self-supporting film. This self-supporting film with side B up was subjected to imidization by continuously heating at a temperature from 150 °C to 370 °C over about 11 min, to give a polyimide film (PI-B13). On side A of this polyimide film (PI-B13) (as shown in Table B), a coverlay was laminated to give a polyimide laminate A (PI-B13).

Example B14

On side B of a polyimide film (PI-B14; a film identical to PI-B13), a coverlay was laminated to give a polyimide laminate A (PI-B14).

Example B15

A self-supporting film was produced as described in Example B13. This self-supporting film with side B up was subjected to imidization by continuously heating at a temperature from 150 °C to 490 °C over about 18 min, to give a polyimide film (PI-B15). On side A of this polyimide film (PI-B15) (as shown in Table B), a coverlay was laminated to give a polyimide laminate A (PI-B15).

Example B16

On side B of a polyimide film (PI-B16; a film identical to PI-B15), a coverlay was laminated to give a polyimide laminate A (PI-B16).

Example B17

The polyamic acid solution II-D was cast as a film on a glass plate, heated at 138 °C for 60 sec. using a hot plate, and then peeled from the glass plate to give a self-supporting film. This self-supporting film with side A up was subjected to imidization by continuously heating at a temperature from 150 °C to 370 °C over about 11 min, to give a polyimide film (PI-B17).

Example B18

A polyimide film (PI-B18) was produced as described in Example B17 except that a self-supporting film produced as described in Example B17 was used with side B up.

Example B19

A self-supporting film produced as described in Example B17 with side A up was subjected to imidization by continuously heating at a temperature from 150 °C to 490 °C over about 18 min, to give a polyimide film (PI-B19).

Example B20

A polyimide film (PI-B20) was produced as described in Example B19 except that a self-supporting film produced as described in Example B17 was used with side B up.

Example B21

The polyamic acid solution II-F was cast as a film on a glass plate, heated at 138 °C for 160 sec. using a hot plate, and then peeled from the glass plate to give a self-supporting film. This self-supporting film with side A up was subjected to imidization by continuously heating at a temperature from 150 °C to 370 °C over about 11 min, to give a polyimide film (PI-B21).

Example B22

A polyimide film (PI-B22) was produced as described in Example B21 except that a self-supporting film produced as described in Example B21 was used with side B up.

Example B25

The polyamic acid solution II-G was cast as a film on a glass plate, heated at 138 °C for 160 sec. using a hot plate, and then peeled from the glass plate to give a self-supporting film. This self-supporting film with side A up was subjected to imidization by continuously heating at a temperature from 150 °C to 370 °C over about 11 min, to give a polyimide film (PI-B25).

Example B26

A polyimide film (PI-B26) was produced as described in Example B25 except that a self-supporting film produced as described in Example B23 was used with side B up.

Example B29

The polyamic acid solution II-H was cast as a film on a glass plate, heated at 138 °C for 210 sec. using a hot plate, and then peeled from the glass plate to give a self-supporting film. This self-supporting film with side A up was subjected to imidization by continuously heating at a temperature from 150 °C to 370 °C over about 11 min, to give a polyimide film (PI-B29).

Example B30

A polyimide film (PI-B30) was produced as described in Example B29 except that a self-supporting film produced as described in Example B27 was used with side B up.

Example B31

A self-supporting film produced as described in Example B27 with side A up was subjected to imidization by continuously heating at a temperature from 150 °C to 490 °C over about 18 min, to give a polyimide film (PI-B31).

Example B32

A Polyimide film (PI-B32) was produced as described in Example B31 except that a self-supporting film produced as described in Example B27 was used with side B up.

Example B33

The polyamic acid solution II-E was cast as a film on a glass plate, heated at 138 °C for 60 sec. using a hot plate, and then peeled from the glass plate to give a self-supporting film with a weight-loss-after-heating of 35.6 % by mass.
This self-supporting film with side B up was fixed at four sides by pintenters and subjected to imidization by heating stepwise in an oven at 150 °C for 50 sec., at 210 °C for 50 sec. and at 370 °C for 30 min, to give a polyimide film (PI-B33). On side A of the polyimide film (PI-B33) (as shown in Table B), a coverlay was laminated to give a polyimide laminate A (PI-B33).

Example B34

On side B of a polyimide film (PI-B34; a film identical to PI-B33), a coverlay was laminated to give a polyimide laminate A (PI-B34).

Example B35

A self-supporting film produced as described in Comparative Example B1 with side B up was subjected to imidization by heating stepwise at 150 °C, 210 °C, 370 °C and then 490 °C (for 50 sec. at each temperature) to give a polyimide film (PI-B35). On side A of the polyimide film (PI-B35) (as described in Table B), a coverlay was laminated to give a polyimide laminate A (PI-B35).

Example B36

On side B of a polyimide film (PI-B36; a film identical to PI-B35), a coverlay was laminated to give a polyimide

laminate A (PI-B36).

Example B37

A polyamic acid solution II-C was cast as a thin film on a glass plate, heated at 138 °C for 60 sec. using a hot plate, and then peeled from the glass plate to give a self-supporting film. A weight-loss-after-heating of the self-supporting film was 36.1 % by mass. This self-supporting film with side A up was subjected to imidization by continuously heating at a temperature from 150 °C to 510 °C over about 18 min, to give a polyimide film (PI-B37) with an average film thickness of 12.5 μm.
On side A of this polyimide film (PI-B37), a coverlay was laminated to give a polyimide laminate A (PI-B37). A peeling strength of the polyimide laminate A (PI-B37) was 0.18 kN/m for the initial A and 0.38 kN/m for the post-heating A. A peeling strength mode of the polyimide laminate A (PI-B37) was "3" for the initial A and "3" for the post-heating A.

Example B38

On side B of a polyimide film (PI-B38; a film identical to PI-B37), a coverlay was laminated to give a polyimide laminate A (PI-B38). A peeling strength of the polyimide laminate A (PI-B38) was 0.24 kN/m for the initial A and 0.50 kN/m for the post-heating A. A peeling strength mode of the polyimide laminate A (PI-B38) was "3" for the initial A and "4" for the post-heating A.

Comparative Example B1

A polyimide film (PI-B37) was produced as described in Example B13 except that for a diamine component, PPD was contained in 100 mol% without using ATDA, and then on side A of the polyimide film (PI-B37), a coverlay was laminated to give a polyimide laminate A (PI-B37).

Comparative Examples B2 to B4

Polyimide film and polyimide laminate A in each example were produced as described in Comparative Example B1, except that a maximum heating temperature and a side on which a coverlay is laminated are as shown in Table B.
Table B

| | Acid component | | Diamine component | | | Weight-loss-after-heating in self-supporting film | Polyimide film | | Maximum heating temperature | Film surface laminated with additive | Peeling strength of polyimide metal laminate A | | Peeling strength mode | |
|---|---|---|---|---|---|---|---|---|---|---|---|---|---|---|
| | s-BPDA | PMDA | PPD | DADE | ATDA | | Type | Thickness | | | Initial A | Post-heating A | Initial A | Post-heating A |
| | mol% | | | | | wt% | | µm | °C | | kN/m | kN/m | | |
| Example B1 | 100 | 0 | 0 | 0 | 100 | 33.6 | PI-B1 | 34.5 | 370 | Side A | 0.84 | 0.67 | 4 | 2 |
| Example B2 | 100 | 0 | 0 | 0 | 100 | 33.8 | PI-B2 | 35 | 370 | Side B | 0.59 | 0.67 | 4 | 2 |
| Example B3 | 100 | 0 | 0 | 0 | 100 | 34.4 | PI-B3 | 36.5 | 490 | Side A | 0.74 | 0.65 | 4 | 2 |
| Example B4 | 100 | 0 | 0 | 0 | 100 | 34.3 | PI-B4 | 34.5 | 490 | Side B | 0.7 | 0.68 | 4 | 2 |
| Example B5 | 100 | 0 | 70 | 0 | 30 | 32.2 | PI-B5 | 12.5 | 370 | Side A | 0.5 | 0.13 | 4 | 3 |
| Example B7 | 100 | 0 | 70 | 0 | 30 | 33.5 | PI-B7 | 12 | 490 | Side A | 0.24 | 0.69 | 4 | 3 |
| Example B8 | 100 | 0 | 70 | 0 | 30 | 32.7 | PI-B8 | 11 | 490 | Side B | 0.23 | 0.64 | 4 | 3 |
| Example B9 | 100 | 0 | 81 | 0 | 19 | 35 | PI-B9 | 36.5 | 370 | Side A | 0.85 | 0.33 | 1 | 3 |
| Example B10 | 100 | 0 | 81 | 0 | 19 | 36.6 | PI-B10 | 35 | 370 | Side B | 1.08 | 0.70 | 4 | 2 |
| Example B11 | 100 | 0 | 81 | 0 | 19 | 37.3 | PI-B11 | 36.5 | 490 | Side A | 0.52 | 0.65 | 4 | 2 |
| Example B12 | 100 | 0 | 81 | 0 | 19 | 37.4 | PI-B12 | 35 | 490 | Side B | 0.52 | 0.68 | 4 | 2 |
| Example B13 | 100 | 0 | 81 | 0 | 19 | 33.7 | PI-B 13 | 11 | 370 | Side A | 0.48 | 0.10 | 4 | 3 |
| Example B14 | 100 | 0 | 81 | 0 | 19 | 33.7 | PI-B14 | 11 | 370 | Side B | 0.49 | 0.17 | 4 | 3 |
| Example B15 | 100 | 0 | 81 | 0 | 19 | 33.3 | PI-B15 | 10 | 490 | Side A | 0.28 | 0.88 | 4 | 4 |
| Example B16 | 100 | 0 | 81 | 0 | 19 | 33.3 | PI-B16 | 10 | 490 | Side B | 0.22 | 0.61 | 4 | 4 |
| Example B19 | 100 | 0 | 90 | 0 | 10 | 35.8 | PI.B17 | 14 | 370 | Side A | 0.38 | 0.16 | 4 | 3 |
| Example B18 | 100 | 0 | 90 | 0 | 10 | 35.7 | PI-B18 | 14.5 | 370 | Side B | 0.42 | 0.18 | 4 | 3 |
| Example B19 | 100 | 0 | 90 | 0 | 10 | 36.9 | PI-B19 | 15.5 | 490 | Side A | 0.44 | 0.26 | 4 | 3 |

(continued)

| | mol% | | | | | wt% | | μm | °C | | kN/m | kN/m | | |
|---|---|---|---|---|---|---|---|---|---|---|---|---|---|---|
| Example B20 | 100 | 0 | 90 | 0 | 10 | 38.6 | PI-B20 | 15.5 | 490 | Side B | 0.37 | 0.37 | 4 | 3 |
| Example B21 | 0 | 100 | 0 | 0 | 100 | 35.5 | PI-B21 | 38.5 | 370 | Side A | 0.93 | 0.67 | 4 | 2 |
| Example B22 | 0 | 100 | 0 | 0 | 100 | 32.3 | PI-B22 | 35.5 | 370 | Side B | 0.69 | 0.73 | 4 | 2 |
| Example B25 | 0 | 100 | 20 | 0 | 80 | 29.5 | PI-B25 | 35 | 370 | Side A | 0.62 | 0.61 | 4 | 2 |
| Example B26 | 0 | 100 | 20 | 0 | 80 | 31.9 | PI-B26 | 35 | 370 | Side B | 1.08 | 0.62 | 4 | 2 |
| Example B29 | 80 | 20 | 0 | 20 | 80 | / | PI-B29 | 37 | 370 | Side A | 0.78 | 0.69 | 4 | 2 |
| Example B30 | 80 | 20 | 0 | 20 | 80 | / | PI-B30 | 37.5 | 370 | Side B | 0.86 | 0.76 | 4 | 2 |
| Example B31 | 80 | 20 | 0 | 20 | 80 | / | PI-B31 | 34.5 | 490 | Side A | 0.69 | 0.60 | 4 | 2 |
| Example B32 | 80 | 20 | 0 | 20 | 80 | / | PI-B32 | 36.5 | 490 | Side B | 0.66 | 0.67 | 4 | 2 |
| Example B33 | 100 | 0 | 93.8 | 0 | 6.2 | 35.6 | PI-B33 | 12 | 370 | Side A | 0.39 | 0.23 | 1 | 3 |
| Example B34 | 100 | 0 | 93.8 | 0 | 6.2 | 35.6 | PI-B34 | 12 | 370 | Side B | 0.29 | 0.21 | 4 | 3 |
| Example B35 | 100 | 0 | 93.8 | 0 | 6.2 | 35.8 | PI-B35 | 11.5 | 490 | Side A | 0.19 | 0.25 | 4 | 3 |
| Example B36 | 100 | 0 | 93.8 | 0 | 6.2 | 35.8 | PI-B36 | 11.5 | 490 | Side B | 0.19 | 0.25 | 4 | 3 |
| Comparative Example B1 | 100 | 0 | 100 | 0 | 0 | | PI-B37 | 13 | 370 | Side A | 0.27 | 0.07 | 3 | 3 |
| Comparative Example B2 | 100 | 0 | 100 | 0 | 0 | | PI-B38 | 12.5 | 370 | Side B | 0.38 | 0.12 | 4 | 3 |
| Comparative Example B3 | 100 | 0 | 100 | 0 | 0 | | PI-B39 | 12.5 | 490 | Side A | 0.25 | 0.10 | 3 | 3 |
| Comparative Example B4 | 100 | 0 | 100 | 0 | 0 | | PI-B40 | 12.5 | 490 | Side B | 0.32 | 0.16 | 4 | 3 |

For Example B, the followings are found.

1) Examples B13 and B14 exhibit more excellent post-heating peeling strength compared to Example B15 or B16. This is presumably due to influence of a maximum heating temperature of the film.
2) For Examples B1 to B36, a polyimide laminate B exhibits higher initial peeling strength than a polyimide film in Comparative Examples, which is cured at the same temperature and in which an adhesive is laminated on the same side. This is presumably due to influence of a content of the diamine represented by general formula (1).
3) For Examples B1 to B36, a polyimide laminate B exhibits higher post-heating peeling strength than a polyimide film in Comparable Examples, which is cured at the same temperature and in which an adhesive is laminated on the same side. This is presumably due to influence of a content of the diamine represented by general formula (1).
4) In Examples B1 to B20, a ratio of post-heating peeling strength/initial peeling strength is as large as about 0.26 to 3.1. This is presumably due to influence of a content of the diamine represented by general formula (1).
5) In Example B21 to B32 in which PMDA is added as an acid component, a ratio of post-heating peeling strength/ initial peeling strength is as large as about 0.57 to 1.06. Furthermore, peeling mode is cohesion failure of an adhesive, so that adhesiveness could be higher than the indicated numerical value.

<<Example Part III (Examples corresponding to Part 1 and Part 3)>>

<u>Preparation of a polyamic acid solution III-A</u>

In a polymerization vessel were charged N,N-dimethylacetamide (DMAc), paraphenylene diamine (PPD) and 2,4-bis(4-aminoanilino)-6-anilino-1,3,5-triazine(ATDA) in predetermined amounts. The amount of ATDA was 19 mol% based on the total diamine components. Then, to the mixture, 3,3',4,4'-biphenyltetracarboxylic dianhydride (s-BPDA) was added portionwise with stirring at 40 °C to a substantially equimolar amount to the total diamine components to initiate a reaction, giving a polyamic-acid polymerization solution (polyimide precursor solution) with a solid concentration of 18 % by mass. Then, to this polyamic-acid polymerization solution, monostearyl phosphoric ester triethanolamine salt was added in a proportion of 0.25 parts by mass based on 100 parts by mass of the polyamic acid and the mixture was homogeneously mixed to give a polyamic acid solution III-A. A rotational viscosity of the polyamic acid solution III-A at 30 °C was 170 Pa ·s.

<u>Preparation of a polyamic acid solution III-B</u>

In a polymerization vessel were charged N,N-dimethylacetamide (DMAc) and paraphenylene diamine (PPD) in predetermined amounts. Then, to the mixture, 3,3',4,4'-biphenyltetracarboxylic dianhydride (s-BPDA) was added portionwise with stirring at 40 °C to a substantially equimolar amount to the total diamine components to initiate a reaction, giving a polyamic-acid polymerization solution (polyimide precursor solution) with a solid concentration of 18 % by mass. Then, to this polyamic-acid polymerization solution, monostearyl phosphoric ester triethanolamine salt was added in a proportion of 0.25 parts by mass based on 100 parts by mass of the polyamic acid and the mixture was homogeneously mixed to give a polyamic acid solution III-B. A rotational viscosity of the polyamic acid solution III-B at 30 °C was 104 Pa ·s.

<u>Preparation of a polyamic acid solution III-C</u>

In a polymerization vessel were charged N,N-dimethylacetamide (DMAc) and 2,4-bis(4-aminoanilino)-6-anilino-1,3,5-triazine(ATDA) in predetermined amounts. Then, to the mixture, 3,3',4,4'-biphenyltetracarboxylic dianhydride (s-BPDA) was added portionwise with stirring at 40 °C to a substantially equimolar amount to the total diamine components to initiate a reaction, giving a polyamic-acid polymerization solution (polyimide precursor solution) with a solid concentration of 18 % by mass. A rotational viscosity of the polyamic acid solution III-C at 30 °C was 107 Pa ·s.

<u>Preparation of a coating solution III-1</u>

The polyamic acid solution III-C was diluted by adding DMAc in such an amount that a solid concentration became 2.5 wt%, to prepare a coating solution III-1. A viscosity of the coating solution III-1 was 10.2 mPa ·s.

<u>Preparation of a coating solution III-2</u>

The polyamic acid solution III-C and the polyamic acid solution III-B were combined so as to satisfy a molar ratio of {a solid content in the polyamic acid solution III-C}/{a solid content in the polyamic acid solution III-B} = 70/30. Then, the mixture was diluted by adding DMAc in such an amount that a total solid concentration became 2.5 wt%, to

prepare a coating solution III-2. A viscosity of the coating solution III-2 was 9.95 mPa ·s.

Preparation of a coating solution III-3

The polyamic acid solution III-C and the polyamic acid solution III-B were combined so as to satisfy a molar ratio of {a solid content in the polyamic acid solution III-C}/{a solid content in the polyamic acid solution III-B} = 37/67. Then, the mixture was diluted by adding DMAc in such an amount that a total solid concentration became 2.5 wt%, to prepare a coating solution III-3. A viscosity of the coating solution III-3 was 10.9 mPa ·s.

Preparation of a coating solution III-4

The polyamic acid solution III-C and the polyamic acid solution III-B were combined so as to satisfy a molar ratio of {a solid content in the polyamic acid solution III-C}/{a solid content in the polyamic acid solution III-B} = 13/87. Then, the mixture was diluted by adding DMAc in such an amount that a total solid concentration became 2.5 wt%, to prepare a coating solution III-4. A viscosity of the coating solution III-4 was 11.0 mPa ·s.

Example C1

The polyamic acid solution III-B was extruded by continuously casting from a slit in a T-die mold to a metal support in a flat belt-form in a drying furnace to form a thin film, which was heated at 145 °C for a predetermined period and peeled from the support to provide a self-supporting film. The self-supporting film thus produced had a weight-loss-after-heating of 39.1 % by mass and an imidization rate of the self-supporting film was 10.4 % in side A and 16.7 % in side B.

Then, the self-supporting film was continuously carried while the coating solution III-1 was applied on side A of the self-supporting film using a die coater (application amount: 6 g/$m^2$), and the film was passed through a drying furnace at 40 °C.

Subsequently, this self-supporting film, which was gripped by both sides in a width direction, was inserted into a continuous heating furnace (curing furnace) so that the film was heated for imidization under the conditions from 100 °C to a maximum heating temperature of 480 °C, to produce a lengthy polyimide film (PI-C1).

Using the polyimide film (PI-C1), a metal was laminated on side A by wet plating as described in the section "Evaluation method" to produce a polyimide-metal laminate (PI-C1).

Again, in the following examples, a side on which a metal layer is formed is, unless otherwise stated, a side to which a coating solution is applied.

Again, in the following examples, a peeling strength was, unless otherwise stated, measured using a polyimide-metal laminate produced by wet or dry plating described in the section "Evaluation method". The results for each example are shown in Table C (Tables C1 and C2). A polyimide laminate produced by laminating a coverlay is called, for example, a polyimide laminate (PI-C1) using the same name (for example, PI-C1) of a polyimide film.

Table C (Tables C1 and C2) also shows a coating solution, a coating surface (a surface on which a metal layer is formed), an average thickness of a polyimide film obtained, the other conditions and the results.

Example C2

A lengthy polyimide film (PI-C2) was produced as described in Example C1, except that the coating solution III-2 was applied on side A of a self-supporting film using a die coater.

Example C3

A lengthy polyimide film (PI-C3) was produced as described in Example C1, except that the coating solution III-3 was applied on side A of a self-supporting film using a die coater and the film was heated for imidization under the conditions from 100 °C to a maximum heating temperature of 480 °C.

Example C4

A lengthy polyimide film (PI-C4) was produced as described in Example C1, except that the coating solution III-4 was applied on side A of a self-supporting film using a die coater and the film was heated for imidization under the conditions from 100 °C to a maximum heating temperature of 480 °C.

Example C5

The polyamic acid solution III-B was extruded by continuously casting from a slit in a T-die mold to a metal support in a flat belt-form in a drying furnace to form a thin film, which was heated at 145 °C for a predetermined period and peeled from the support to provide a self-supporting film. The self-supporting film thus produced had a weight-loss-after-heating of 39.6 % by mass and an imidization rate of the self-supporting film was 9.9 % in side A and 17.2 % in side B.

Then, the self-supporting film was continuously carried while the coating solution III-1 was applied on side B of the self-supporting film using a die coater (application amount: 6 g/$m^2$), and the film was passed through a drying furnace at 40 °C.

Subsequently, this self-supporting film, which was gripped by both sides in a width direction, was inserted into a continuous heating furnace (curing furnace) so that the film was heated for imidization under the conditions of 100 °C to a maximum heating temperature of 480 °C, to produce a lengthy polyimide film (PI-C5).

Example C6

A lengthy polyimide film (PI-C6) was produced as described in Example C5, except that the coating solution III-2 was applied on side B of a self-supporting film using a die coater.

Example C7

A lengthy polyimide film (PI-C7) was produced as described in Example C5, except that the coating solution III-3 was applied on side B of a self-supporting film using a die coater.

Example C8

A lengthy polyimide film (PI-C8) was produced as described in Example C5, except that the coating solution III-4 was applied on side B of a self-supporting film using a die coater.

Comparative Example C1

A lengthy polyimide film (PI-C9) was produced as described in Example C6, except that a coating solution was not applied on a self-supporting film and the film was heated for imidization under the conditions from 100 °C to a maximum heating temperature of 490 °C.

Using the polyimide film (PI-C9), a metal was laminated on side B by wet plating, to produce a polyimide-metal laminate (PI-C9).

Reference Example C1

A polyamic acid solution III-A was casted as a thin film on a glass plate, heated at 138 °C for 60 sec. using a hot plate and peeled from the glass plate to produce a self-supporting film. This self-supporting film with side A up was fixed at four sides by pintenters and subjected to imidization by continuously heating in an oven at a temperature from 150 °C to 490 °C for about 18 min to produce a polyimide film (PI-C10).

Using the polyimide film (PI-C10), a metal was laminated on side A by wet plating to produce a polyimide-metal laminate (PI-C10). A peeling strength of the polyimide-metal laminate (PI-C10) was measured and the results are shown in Table C1.

Examples C9 to 16

Using the polyimide films PI-C1 to C8 produced in Examples C1 to 8, a metal was laminated on a coating surface by dry plating as described in the section "Evaluation method", to produce a polyimide-metal laminate (PI-C11 to 18). The results are shown in Table C2.

Comparative Example C2

Using the polyimide film PI-C9 produced in Comparative Example C1, a metal was laminated on either side A or side B by dry plating as described in the section "Evaluation method", to produce a polyimide-metal laminate. The results are shown in Table C2.

Table C1

| | Acid component | Diamine component | | Solution for coating | Plated surface | Polyimide film | | Plating type | Peeling strength of a polyimide metal laminate Peeling laminate | | | | |
|---|---|---|---|---|---|---|---|---|---|---|---|---|---|
| | s-BPDA | PPD | ATDA | | | Type | Thickness | | Initial | Post heating | Post heating | Cooker | Cooker |
| | | | | | | | | | A1 | A2 | A3 | A4 | A5 |
| | mol% | | | | | | μm | | kN/m | | | | |
| Example C1 | 100 | 0 | 100 | III-1 | A | PI-C1 | 34 | Wet | 0.31 | 0.37 | 0.58 | | |
| Example C2 | 100 | 30 | 70 | III-2 | A | PI-C2 | 34 | Wet | 0.6 | 0.6 | 0.67 | 0.44 | 0.48 |
| Example C3 | 100 | 63 | 37 | III-3 | A | PI-C3 | 33.5 | Wet | 0.44 | 0.49 | 0.64 | | |
| Example C4 | 100 | 87 | 13 | III-4 | A | PI-C4 | 34 | Wet | 0.33 | 0.3 | 0.44 | | |
| Example C5 | 100 | 0 | 100 | III-1 | B | PI-C5 | 34.5 | Wet | 0.45 | 0.56 | 0.6 | 0.36 | 0.4 |
| Example C6 | 100 | 30 | 70 | III-2 | B | PI-C6 | 34 | Wet | 0.46 | 0.53 | 0.63 | 0.37 | 0.36 |
| Example C7 | 100 | 63 | 37 | III-3 | B | PI-C7 | 34.5 | Wet | 0.37 | 0.43 | 0.56 | | |
| Example C8 | 100 | 87 | 13 | III-4 | B | PI-C8 | 34.5 | Wet | 0.14 | 0.12 | 0.11 | | |
| Comparative Example C1 | - | - | - | - | B | I-C9 | 34.5 | Wet | 0.05 | 0.05 | 0.05 | - | - |
| Reference Example C1 | - | - | - | - | A | PI-C 10 | 37 | Wet | 0.56 | 0.59 | 0.52 | 0.42 | |

Table C2

| | Acid component | Diamine component | | Solution for coating | Plated surface | Polyimide film | | Plating type | Peeling strength of a polyimide metal laminate | | | | |
|---|---|---|---|---|---|---|---|---|---|---|---|---|---|
| | s-BPDA | PPD | ATDA | | | Type | Thickness | | Initial | Post heating | Post heating | Cooker | Cooker |
| | | | | | | | | | A1 | A2 | A3 | A4 | A5 |
| | mol% | | | | | | μm | | kN/m | | | | |
| Example C9 | 100 | 0 | 100 | III-1 | A | PI-C 11 | 34 | Dry | 0.5 | 0.51 | 0.38 | 0.45 | 0.46 |
| Example C10 | 100 | 30 | 70 | III-2 | A | PI-C 12 | 34 | Dry | 0.42 | 0.4 | 0.26 | 0.32 | 0.32 |
| Example C11 | 100 | 63 | 37 | III-3 | A | PI-C13 | 33.5 | Dry | 0.33 | 0.31 | 0.25 | 0.29 | 0.18 |
| Example C12 | 100 | 87 | 13 | III-4 | A | PI-C 14 | 34 | Dry | 0.21 | 0.16 | 0.11 | 0.15 | 0.09 |
| Example C13 | 100 | 0 | 100 | III-1 | B | PI-C 15 | 34.5 | Dry | 0.52 | 0.43 | 0.39 | 0.39 | 0.35 |
| Example C14 | 100 | 30 | 70 | III-2 | B | PI-C 16 | 34 | Dry | 0.52 | 0.44 | 0.41 | 0.39 | 0.34 |
| Example C15 | 100 | 63 | 37 | III-3 | B | PI-C 17 | 34.5 | Dry | 0.28 | 0.28 | 0.26 | 0.24 | 0.18 |
| Example C16 | 100 | 87 | 13 | III-4 | B | PI-C 18 | 34.5 | Dry | 0.25 | 0.18 | 0.19 | 0.14 | 0.12 |
| Comparative Example C2 | - | - | - | - | A | PI-C9 | 34.5 | Dry | 0.10 | 0.08 | 0.08 | 0.09 | 0.07 |
| Comparative Example C3 | - | - | - | - | B | PI-C9 | 34.5 | Dry | 0.20 | 0.09 | 0.05 | 0.12 | 0.08 |

For these examples, the following is found.

1) In all of Examples C1 to C16, peeling strength of a polyimide-metal laminate in all of the peeling tests A1 to A5 is higher than that in any of Comparative Examples. This is presumably due to influence of a content of the diamine represented by general formula (1).

## Claims

1. A polyimide film comprising at least a polyimide layer (b) and a polyimide layer (a) formed contacting the polyimide layer (b),
wherein the polyimide layer (a) is a polyimide formed from a tetracarboxylic dianhydride component and a diamine component containing a diamine compound represented by general formula (1):

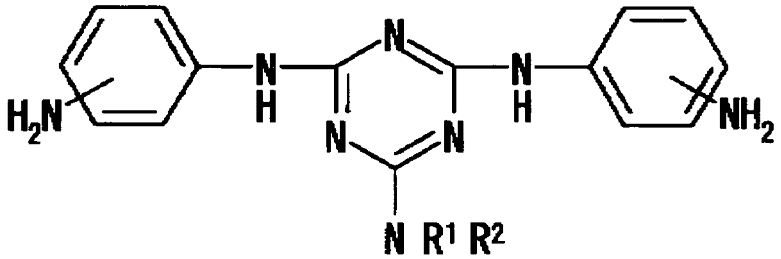
(1)

wherein $R^1$ denotes a hydrogen atom, an alkyl group having 1 to 12 carbon atoms or an aryl group, and $R^2$ denotes an alkyl group having 1 to 12 carbon atoms or an aryl group.

2. The polyimide film according to Claim 1 produced by applying a polymer solution (a) capable of giving the polyimide layer (a) to one side or both sides of a self-supporting film formed from a polyamic acid solution (b) capable of giving the polyimide layer (b) and heating the self-supporting film.

3. The polyimide film according to Claim 1 produced by heating a multilayer liquid film which is a laminate of a liquid film of a polyamic acid solution (b) capable of giving the polyimide layer (b) and a liquid film of a polymer solution (a) capable of giving the polyimide layer (a).

4. The polyimide film according to Claim 2 or 3, wherein the polymer solution (a) is a polyamic acid solution (a) capable of giving the polyimide layer (a).

5. The polyimide film according to any one of Claims 1 to 4, wherein the diamine compound represented by general formula (1) is 2,4-bis(4-aminoanilino)-6-anilino-1, 3, 5-triazine.

6. The polyimide film according to any one of Claims 1 to 5, wherein the diamine component comprises the diamine compound represented by general formula (1) in a range of 10 to 100 mol%.

7. The polyimide film according to any one of Claims 1 to 5, wherein the diamine component comprises the diamine compound represented by general formula (1) in a range of 25 to 100 mol%.

8. The polyimide film according to any one of Claims 1 to 7, wherein the diamine component further comprises phenylene diamine or diaminodiphenyl ether.

9. The polyimide film according to any one of Claims 1 to 8, wherein a polyimide constituting the polyimide layer (b) is produced from a tetracarboxylic dianhydride component comprising 3,3',4,4'-biphenyltetracarboxylic dianhydride and/or pyromellitic dianhydride and a diamine component comprising phenylene diamine and/or diaminodiphenyl ether.

10. Use of the polyimide film according to any one of Claims 1 to 9 in an application where an adhesive layer is directly formed on the surface of the polyimide layer (a).

**11.** Use of the polyimide film according to any one of Claims 1 to 9 in an application where a metal layer is formed on the surface of the polyimide layer (a) by dry or wet plating.

**12.** A polyimide laminate comprising the polyimide film according to any one of Claims 1 to 9 and an adhesive layer formed on the surface of the polyimide layer (a) in the polyimide film.

**13.** A polylmide-metal laminate wherein a metal layer is laminated in contact with the adhesive layer in the polyimide laminate according to Claim 12.

**14.** A polyimide-metal laminate comprising the polyimide film according to any one of Claims 1 to 9 and a metal layer formed on the surface of the polyimide layer (a) in the polyimide film by dry or wet plating.

**15.** A process for manufacturing the polyimide film according to any one of Claims 1 to 9, comprising:

a step of forming a self-supporting film using a polyamic acid solution (b) capable of giving the polyimide layer (b),
a step of applying a polymer solution (a) capable of giving the polyimide layer (a) on one side or both sides of the self-supporting film, and
a heating step of heating the self-supporting film on which the polymer solution (a) is applied.

**16.** A process for manufacturing the polyimide film according to any one of Claims 1 to 9, comprising:

a step of flow-casting a polyamic acid solution (b) capable of giving the polyimide layer (b) and a polymer solution (a) capable of giving the polyimide layer (a) on a support to form a multilayer liquid film, and
a heating step of heating the multilayer liquid film.

**17.** The process according to Claim 15 or 16, wherein in the heating step, the self-supporting film is heated under such conditions that a maximum heating temperature is 350 °C or higher.

**18.** The process according to Claim 15 or 16, wherein in the heating step, the self-supporting film is heated under such conditions that a maximum heating temperature is 450 °C or higher.

**19.** The process according to Claim 15 or 16, wherein in the heating step, the self-supporting film is heated under such conditions that a maximum heating temperature is 470 °C or higher.

**INTERNATIONAL SEARCH REPORT**

International application No.
PCT/JP2011/052856

A. CLASSIFICATION OF SUBJECT MATTER
*C08G73/10*(2006.01)i, *B32B15/08*(2006.01)i, *B32B15/088*(2006.01)i, *B32B27/34*(2006.01)i, *C08J5/18*(2006.01)i

According to International Patent Classification (IPC) or to both national classification and IPC

B. FIELDS SEARCHED

Minimum documentation searched (classification system followed by classification symbols)
C08G73/00-73/26, B32B1/00-35/00, C08J5/00-5/22

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)
CAplus(STN), REGISTRY(STN)

C. DOCUMENTS CONSIDERED TO BE RELEVANT

| Category* | Citation of document, with indication, where appropriate, of the relevant passages | Relevant to claim No. |
|---|---|---|
| A | JP 2005-154643 A (Tamura Kaken Corp.), 16 June 2005 (16.06.2005), claims 1 to 9; paragraph [0049] (Family: none) | 1-19 |
| A | JP 2009-154541 A (Ube Industries, Ltd.), 16 July 2009 (16.07.2009), claims 1 to 8 (Family: none) | 1-19 |
| A | JP 2009-280694 A (Ube Industries, Ltd.), 03 December 2009 (03.12.2009), claims 1 to 3; paragraph [0007] (Family: none) | 1-19 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 19 April, 2011 (19.04.11) | 10 May, 2011 (10.05.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2011/052856

C (Continuation). DOCUMENTS CONSIDERED TO BE RELEVANT

| Category* | Citation of document, with indication, where appropriate, of the relevant passages | Relevant to claim No. |
|---|---|---|
| A | JP 48-008272 B1 (CIBA-Geigy AG.), 13 March 1973 (13.03.1973), claims (Family: none) | 1-19 |
| A | JP 52-003388 B1 (CIBA-Geigy AG.), 27 January 1977 (27.01.1977), claims (Family: none) | 1-19 |
| A | JP 2006-307112 A (Nippon Fusso Co., Ltd.), 09 November 2006 (09.11.2006), claims 1 to 5 (Family: none) | 1-19 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 3803075 A
- JP 2009263570 A
- JP 2009087763 A
- JP 2010031102 A